# EUROPEAN PATENT APPLICATION

(11) **EP 4 572 582 A1**
(43) Date of publication of application: **18.06.2025**
(21) Application number: 24214691.8
(22) Date of filing: 22.11.2024
(51) Int. Cl.: H10K 59/131

(54) **DISPLAY DEVICE AND HEAD-MOUNTED DISPLAY DEVICE INCLUDING THE SAME**

(30) Priority: 27.11.2023 KR 20230166790
(71) Applicant: Samsung Display Co., Ltd., Yongin-si, Gyeonggi-do 17113 (KR)
(72) Inventor: NO, Sang Yong, Yongin-si (KR); KIM, Kyung Ho, Yongin-si (KR); LEE, Gi Chang, Yongin-si (KR)
(74) Representative: Marks & Clerk LLP

(57) **Abstract**

A display device and head-mounted display device including the same are provided. The display device includes a first monocrystalline semiconductor substrate (110) where first transistors (PTR1) are located, and a second monocrystalline semiconductor substrate (210) where second transistors (PTR2) are located, having a planar area that is greater than a planar area of the first monocrystalline semiconductor substrate (110), located above the first monocrystalline semiconductor substrate, including a display area (DAA) where subpixels (SP1 - SP3) including light-emitting elements (IL) are located, defining first through holes (TSV1) in which first conductive vias (RVA1) that are electrically connected to data lines (DL), which are connected to the subpixels, are located, and defining second through holes (TSV2) in which second conductive vias (RVA2) that are electrically connected to a gate-driving part (610, 620), which is electrically connected to the subpixels (SP1 - SP3), are located.

## Description

### BACKGROUND

### 1. Field

The present disclosure relates to a display device, and a head-mounted display (HMD) device including the same.

### 2. Description of the Related Art

A head-mounted display (HMD) device can be worn on a user's head in the form of glasses or a helmet, serving as a display device that forms an image at a short distance in front of the user's eyes. The HMD device is capable of implementing virtual reality (VR) or augmented reality (AR).

The HMD device enlarges an image displayed by a small display device using multiple lenses. Therefore, a display device for the HMD device may suitably provide high-resolution images, for example, images with a resolution of over 3000 pixels per inch (PPI). To achieve this, an organic light-emitting diode (OLED)-on-silicon (OLEDoS) display device, which is a high-resolution small-size OLED display device, is being utilized. The OLEDoS display device is a device that displays an image using OLEDs located on a semiconductor wafer substrate where complementary metal-oxide semiconductor (CMOS) elements are arranged.

### SUMMARY

Aspects of the present disclosure provide an ultrasmall display device that includes a plurality of different monocrystalline semiconductor substrates and a head-mounted display (HMD) device including the display device.

Aspects of the present disclosure also provide a display device capable of reducing or minimizing the area occupied by through holes used to connect two different semiconductor substrates, and an HMD device including the display device.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to one or more embodiments of the disclosure, a display device includes a first monocrystalline semiconductor substrate where first transistors are located, and a second monocrystalline semiconductor substrate where second transistors are located, having a planar area that is greater than a planar area of the first monocrystalline semiconductor substrate, located above the first monocrystalline semiconductor substrate, including a display area where subpixels including light-emitting elements are located, defining first through holes in which first conductive vias that are electrically connected to data lines, which are connected to the subpixels, are located, and defining second through holes in which second conductive vias that are electrically connected to a gate-driving part, which is electrically connected to the subpixels, are located.

A number of the first through holes may be greater than a number of the second through holes.

A number of the first through holes may be equal to a number of rows of the subpixels.

The display device may further include a circuit board above pads, which are located in a non-display area around the display area of the second monocrystalline semiconductor substrate, wherein the second monocrystalline semiconductor substrate defines third through holes overlapping the pads.

The first through holes may overlap with the circuit board in a thickness direction.

The third through holes may overlap the circuit board and the first monocrystalline semiconductor substrate.

The first through holes might not overlap with the pads.

The display device may further include a circuit board on a bottom surface of the first monocrystalline semiconductor substrate, wherein the first monocrystalline semiconductor substrate defines third through holes in which there are conductive vias connected to the circuit board.

The display device may further include a drive circuit part on the circuit board.

A width of the first monocrystalline semiconductor substrate in one direction may be greater than a width of the display area in the one direction.

The first through holes and the second through holes may be in a non-display area around the display area in plan view.

The data lines may extend in a first direction above the second monocrystalline semiconductor substrate, and are electrically connected to some of the first transistors, wherein the display device further includes scan lines electrically connected to the gate-driving part, and extending in a second direction crossing the first direction above the second monocrystalline semiconductor substrate.

The first through holes may be arranged in parallel to the data lines along the first direction.

A number of the first through holes may be equal to a number of the data lines.

The display device may further include a connection wiring layer between the first and second monocrystalline semiconductor substrates, and connected to the first conductive vias and the second conductive vias.

According to one or more embodiments of the disclosure, a head-mounted display (HMD) device includes a frame configured to be worn on a user's body, and corresponding to a user's eyes, display devices in the frame, and lenses above the display devices, wherein the display devices include a first monocrystalline semiconductor substrate where first transistors are located, and a second monocrystalline semiconductor substrate above the first monocrystalline semiconductor substrate and where second transistors are located, wherein the second monocrystalline semiconductor substrate includes a display area where subpixels including light-emitting elements are located, defines first through holes in which first conductive vias electrically connected to data lines that are connected to the subpixels are located, and defines second through holes in which second conductive vias electrically connected to a gate-driving part that is electrically connected to the subpixels are located, and wherein a planar area of the first monocrystalline semiconductor substrate is less than a planar area of the second monocrystalline semiconductor substrate.

A number of the first through holes may be equal to a number of rows of the subpixels.

A width of the first monocrystalline semiconductor substrate in one direction may be greater than a width of the display area in the one direction.

The first through holes and the second through holes may be in a non-display area around the display area.

The HMD device may further include a circuit board above pads, which are located in a non-display area around the display area of the second monocrystalline semiconductor substrate in plan view, wherein the second monocrystalline semiconductor substrate defines third through holes overlapping the pads, and wherein the first through holes overlap with the circuit board in a thickness direction.

According to the aforementioned and other embodiments of the present disclosure, a display includes two different monocrystalline semiconductor substrates, and the fabrication of the lower monocrystalline semiconductor substrate allows for a high production volume per wafer substrate, potentially improving the manufacturing yield.

Moreover, circuit parts can be distributed between the two different monocrystalline semiconductor substrates, and the number of through holes that connect the circuit parts can be reduced or minimized. This display device can alleviate high integration density on a monocrystalline semiconductor substrate with a narrow area.

It should be noted that the aspects of the present disclosure are not limited to those described above, and other aspects of the present disclosure will be apparent from the following description.

According to one or more embodiments of the disclosure, a display device includes a first monocrystalline semiconductor substrate where first transistors of a drive circuit part are located, and a second monocrystalline semiconductor substrate where second transistors of a gate-driving part and a pixel circuit part are located, having a planar area that is greater than a planar area of the first monocrystalline semiconductor substrate, located above the first monocrystalline semiconductor substrate, including a display area where subpixels including light-emitting elements are located, defining first through holes in which first conductive vias that are electrically connected to data lines, which are connected to the subpixels, are located, and defining second through holes in which second conductive vias that are electrically connected to a gate-driving part, which is electrically connected to the subpixels, are located, wherein the first monocrystalline semiconductor substrate is embedded within a protective layer having a planar area substantially the same as the planar area of the second monocrystalline semiconductor substrate. The protective layer and embedded first monocrystalline semiconductor substrate may be directly or indirectly bonded to a lower surface of the second monocrystalline semiconductor substrate to provide a monolithic structure of substantially uniform planar area.

At least some of the above and other features of the invention are set out in the claims.

### BRIEF DESCRIPTION OF THE DRAWINGS

The above and other aspects of the present disclosure will become more apparent by describing in detail embodiments thereof with reference to the attached drawings, in which:
FIG. 1 is an exploded perspective view of a display device according to one or more embodiments of the present disclosure;
FIG. 2 is a plan view of an example of a driving part of FIG. 1;
FIG. 3 is a plan view of an example of the display part of FIG. 1;
FIG. 4 is a plan view illustrating the arrangement of a plurality of wirings located in the display part of FIG. 3;
FIG. 5 is a block diagram of a display device according to one or more embodiments of the present disclosure;
FIG. 6 is an equivalent circuit diagram of a pixel according to one or more embodiments of the present disclosure;
FIG. 7 is a cross-sectional view of the display device according to one or more embodiments of the present disclosure;
FIG. 8 is a bottom view of the display device according to one or more embodiments of the present disclosure;
FIG. 9 is a cross-sectional view of a driving part according to one or more embodiments of the present disclosure;
FIG. 10 is a plan view illustrating the first electrodes, light-emitting areas, and pixel-defining films of multiple subpixels arranged in the display area of a display part according to one or more embodiments of the present disclosure;
FIG. 11 is a plan view illustrating the first electrodes, light-emitting areas, and pixel-defining films of multiple subpixels arranged in the display area of a display part according to one or more other embodiments of the present disclosure;
FIGS. 12 and 13 are cross-sectional views illustrating parts of the display and non-display areas of the display part according to one or more embodiments of the present disclosure;
FIGS. 14 and 15 are cross-sectional views of display devices according to other embodiments of the present disclosure;
FIG. 16 is a cross-sectional view of a display device according to one or more other embodiments of the present disclosure;
FIG. 17 is a bottom view of the display device of FIG. 16.
FIG. 18 is a perspective view of an HMD device according to one or more embodiments of the present disclosure;
FIG. 19 is an exploded perspective view of the HMD device of FIG. 18; and
FIG. 20 is a perspective view of an HMD device according to one or more other embodiments of the present disclosure.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

In the drawings, the relative sizes of elements, layers, and regions may be exaggerated for clarity and/or descriptive purposes. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

The electronic or electric devices and/or any other relevant devices or components according to embodiments of the present disclosure described herein may be implemented utilizing any suitable hardware, firmware (e.g., an application-specific integrated circuit), software, or a combination of software, firmware, and hardware, to process data or digital signals. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Circuit hardware may include, for example, application specific integrated circuits (ASICs), general purpose or special purpose central processing units (CPUs) that is configured to execute instructions stored in a non-transitory storage medium, digital signal processors (DSPs), graphics processing units (GPUs), and programmable logic devices, such as field programmable gate arrays (FPGAs).

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

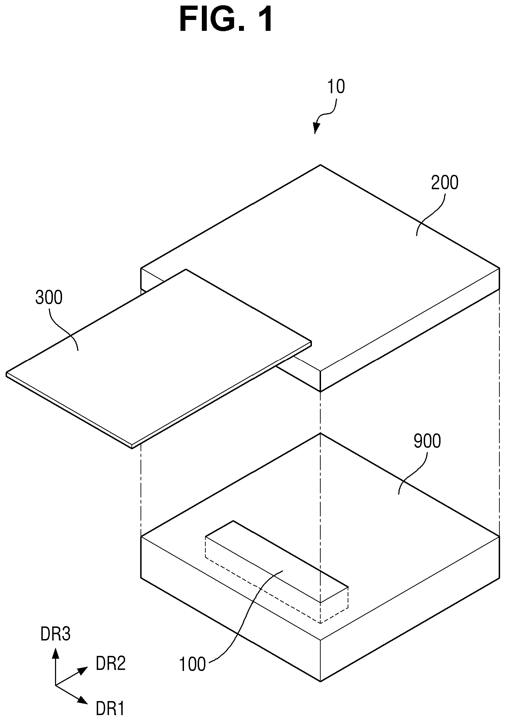

FIG. 1 is an exploded perspective view of a display device according to one or more embodiments of the present disclosure.

Referring to FIG. 1, a display device 10 is a device that displays videos or still images. The display device 10 may be applied to a portable electronic device, such as a mobile phone, a smartphone, a tablet personal computer (PC), a mobile communication terminal, an electronic notebook, an e-book reader, a portable multimedia player (PMP), a navigation system, an ultra-mobile PC (UMPC), etc. For example, the display device 10 may be applied as a display part of a television (TV), a laptop computer, a monitor, a billboard, or an Internet-Of-Thing (IoT) device. Additionally, the display device 10 may also be applied to a smartwatch, a watchphone, or a head-mounted display (HMD) device for implementing virtual reality (VR) and augmented reality (AR).

The display device 10 may include a driving part 100, a display part 200, and a circuit board 300. The display device 10 may further include a protective layer 900, which is located around the driving part 100.

The driving part 100 may have a similar planar shape to a rectangle. For example, the driving part 100 may have a rectangle-like planar shape having sides in a first direction DR1 and sides in a second direction DR2, which intersects the first direction DR1. The lengths of the sides in the first direction DR1 and the sides in the second direction DR2 of the driving part 100 may be different. The corners where the sides, in the first direction DR1, and the sides, in the second direction DR2, of the driving part 100 meet may be formed with a curvature (e.g., predetermined curvature), or may be formed at right angles. The planar shape of the driving part 100 is not particularly limited, and the driving part 100 may also be formed in a shape similar to a polygon, a circle, or an ellipse.

The display part 200 may be located on the driving part 100. In the display device 10, the driving part 100 and the display part 200 may be joined to each other. Unlike the driving part 100, the display part 200 may have a square-like shape. For example, the driving part 100 may have a planar shape that is similar to a square, and may have sides in the first direction DR1 and sides in the second direction DR2 of the same length. The planar shape of the display part 200 is not particularly limited, and the display part may also be formed in a shape similar to a polygon, a circle, or an ellipse. The planar shape of the display device 10 may conform to the planar shape of the display part 200, but the present disclosure is not limited thereto.

The display part 200 may have a larger planar area than the driving part 100. The driving part 100 and the display part 200 may include different substrates, and the different substrates may have different areas. Different elements may be formed in the driving part 100 and the display part 200, and may be individually formed on different substrates. The display device 10 may be fabricated by forming a plurality of elements with different sizes, linewidths, and manufacturing processes on different substrates and then joining the plurality of elements, offering the advantage of improving product performance and manufacturing yield. This will be described later with reference to other drawings.

The circuit board 300 may be electrically connected to a plurality of pads in the pad areas of the display part 200 using a conductive adhesive member, such as an anisotropic conductive film. The circuit board 300 may be a flexible printed circuit board or a flexible film. FIG. 1 illustrates the circuit board 300 as being unfolded, but the circuit board 300 may be bent. When the circuit board 300 is bent, one end of the circuit board 300 may be located on the bottom surface of the driving part 100. The other end of the circuit board 300 may be connected to the pads in the pad areas of the display part 200 using a conductive adhesive member. Alternatively, in other embodiments, the circuit board 300 may be attached to the bottom surface of the driving part 100.

In one or more embodiments, the display device 10 may further include a heat dissipation layer, which overlaps with the driving part 100 and the display part 200 in a third direction DR3. The heat dissipation layer may be located on the bottom surface of the driving part 100, and may dissipate heat generated from the driving part 100 and the display part 200. The heat dissipation layer may include a layer of a metal with high thermal conductivity, such as graphite, silver, copper, or aluminum.

The protective layer 900 may surround the driving part 100, and may be located on the bottom surface of the display part 200. The protective layer 900 may reduce the step difference caused by the difference between the areas of the driving part 100 and the display part 200, and may also protect the driving part 100 and the display part 200.

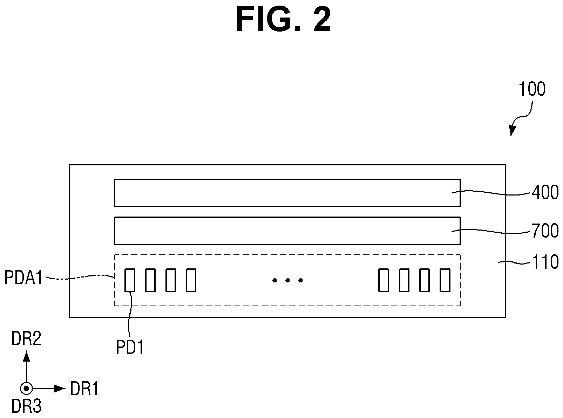

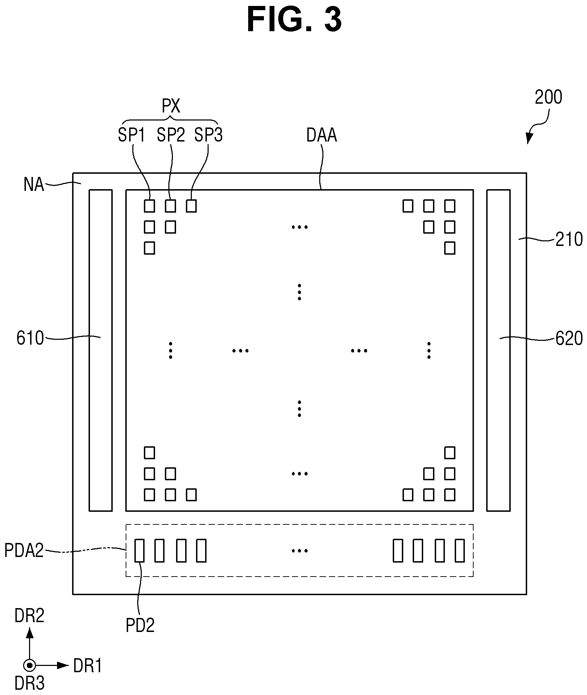

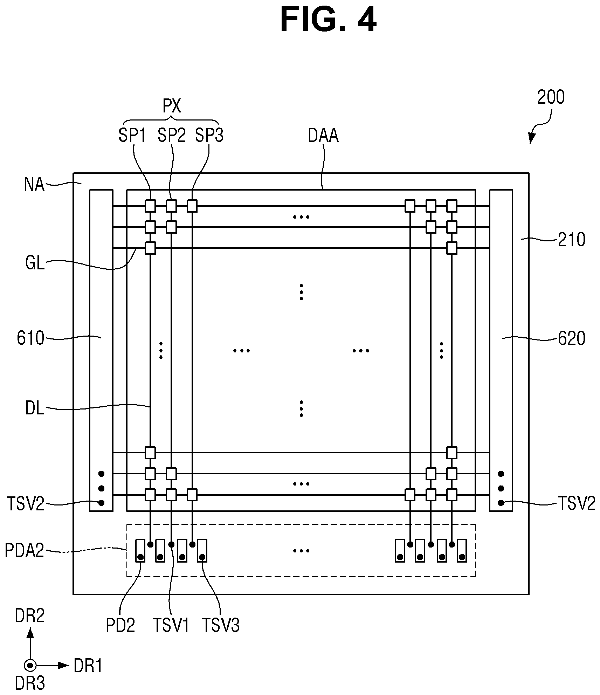

FIG. 2 is a plan view of an example of the driving part of FIG. 1. FIG. 3 is a plan view of an example of the display part of FIG. 1. FIG. 4 is a plan view illustrating the arrangement of a plurality of wirings located in the display part of FIG. 3.

Referring to FIGS. 2 through 4, the driving part 100 of the display device 10 may include drive circuit elements of the display device 10. The driving part 100 may include a first monocrystalline semiconductor substrate 110, a drive circuit part 400, which is formed on the first monocrystalline semiconductor substrate 110, and a data drive part 700.

The first monocrystalline semiconductor substrate 110 may be a silicon (Si) substrate, a germanium (Ge) substrate, or a silicon-germanium (SiGe) substrate. A plurality of first transistors may be formed on the first monocrystalline semiconductor substrate 110, and may be electrically connected to form the drive circuit part 400 and the data drive part 700. The first transistors may be formed through a semiconductor process. For example, the first transistors may be formed as complementary metal-oxide semiconductor (CMOS) transistors.

The drive circuit part 400 may be illustrated as being located at an upper part the driving part 100 with the data drive part 700 and the first pad area PDA1 located therebelow, but the present disclosure is not limited thereto. That is, the locations of the drive circuit part 400 and the data drive part 700 in the driving part 100 may vary depending on the design structure of a plurality of circuit elements formed on the first monocrystalline semiconductor substrate 110.

A first pad area PDA1 may include a plurality of first pads PD1, which are located in the first direction DR1. The first pads PD1 may be electrically connected to a plurality of second pads PD2 of the display part 200, and may thereby be electrically connected to the circuit board 300. The first pads PD1 may transmit electrical signals applied from the circuit board 300 to the drive circuit part 400, a gate-driving part (610 and 620), and the data drive part 700.

The display part 200 may include a second monocrystalline semiconductor substrate 210, and a plurality of pixels PX and the gate-driving part (610 and 620), which are formed on the second monocrystalline semiconductor substrate 210. The display part 200 may include a display area DAA where the pixels PX are located, and a non-display area NA around the display area DAA. The gate-driving part (610 and 620) and a second pad area PDA2 may be located in the non-display area NDA.

The second monocrystalline semiconductor substrate 210 may be a Si substrate, a Ge substrate, or a SiGe substrate. A plurality of second transistors may be formed on the second monocrystalline semiconductor substrate 210, and may be electrically connected to one another to form the gate-driving part (610 and 620), and a pixel circuit part for the illumination of the pixels PX. The second transistors may be formed through a semiconductor process. For example, the second transistors may be formed as CMOS transistors.

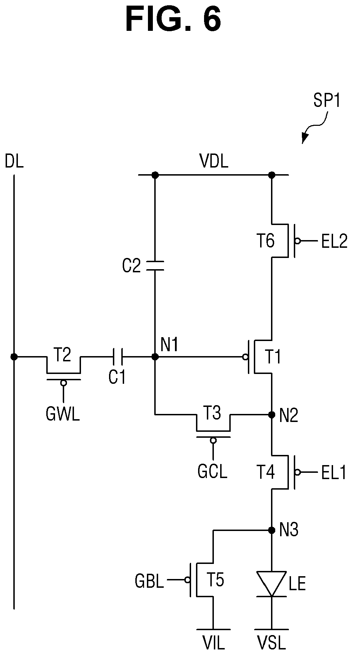

The display area DAA may include the pixels PX, which include light-emitting elements. Each of the pixels PX may include three subpixels (e.g., first, second, and third subpixels SP1, SP2, and SP3). Three subpixels (e.g., first, second, and third subpixels SP1, SP2, and SP3) may form a pixel PX together to display a color, but the present disclosure is not limited thereto. Alternatively, each of the pixels PX may include more than three subpixels. A plurality of subpixels (SP1, SP2, and SP3) may be arranged in a matrix form in the first and second directions DR1 and DR2. Each of the subpixels (SP1, SP2, and SP3) may be electrically connected to a pixel circuit consisting of multiple second transistors formed on the second monocrystalline semiconductor substrate 210, as illustrated in FIG. 6. Each of the subpixels (SP1, SP2, and SP3) includes light-emitting elements, and the light-emitting elements may emit light according to an electrical signal applied from the corresponding pixel circuit in the display area DAA.

Some of the subpixels (SP1, SP2, and SP3), which are located in the display area DAA of the display part 200, may overlap with the driving part 100 in the thickness direction of the display device 10, and other subpixels (SP1, SP2, and SP3) may not overlap with the driving part 100. The driving part 100 may have a smaller area than the display part 200, and may be adjacent to one side of the display part 200. Accordingly, only some of the subpixels (SP1, SP2, and SP3) may overlap with the driving part 100 in the thickness direction.

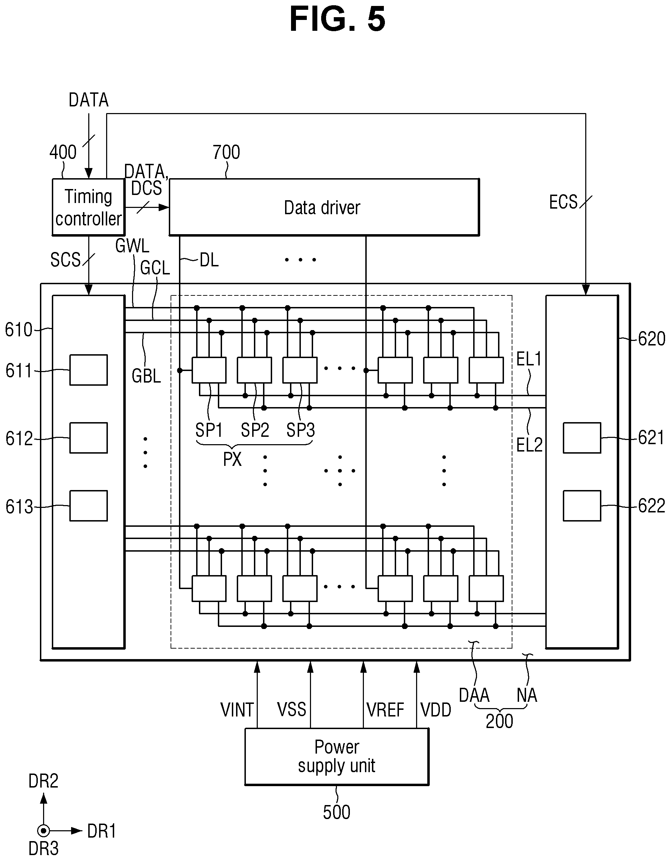

A plurality of scan lines GL, which extend in the first direction DR1 and are arranged in the second direction DR2, and a plurality of data lines DL, which extend in the second direction DR2 and are arranged in the first direction DR1, may be located in the display area DAA. Referring to FIG. 5, the scan lines GL may include different types of scan lines, for example, first scan lines GWL, second scan lines GCL, and third scan lines GBL, and may further include emission control lines (EL1 and EL2). The scan lines GL and the data lines DL may be connected to the subpixels (SP1, SP2, and SP3) in the display area DAA. The scan lines GL may be electrically connected to the gate-driving part (610 and 620) of the display part 200, and the data lines DL may be electrically connected to the data drive part 700 of the driving part 100. The data lines DL may be electrically connected to the data drive part 700 of the driving part 100 through first through holes TSV1.

The subpixels (SP1, SP2, and SP3) may be electrically connected to the scan lines GL and the data lines DL. The subpixels (SP1, SP2, and SP3) may receive data voltages from the data lines DL according to scan signals from the scan lines GL, and may enable their light-emitting elements to emit light according to the data voltages.

The non-display area NA may surround the display area DAA. The non-display area NA may be an area where no pixels PX are located so that no light is emitted. The non-display area NA may include the gate-driving part (610 and 620), the second pad area PDA2, and a plurality of through holes (TSV1, TSV2, and TSV3).

The gate-driving part (610 and 620) may include a scan driver 610 and an emission driver 620. The scan driver 610 may include a plurality of scan transistors, which are formed on the second monocrystalline semiconductor substrate 210, and the light-emitting driver 620 may include a plurality of emission transistors, which are formed on the second monocrystalline semiconductor substrate 210. The scan transistors and the emission transistors may be formed through a semiconductor process. For example, the scan transistors and the emission transistors may be formed as CMOS transistors.

The scan driver 610 may be located on one side of the display area DAA (e.g., in the first direction DR1, or on the left side of the display area DAA). The light-emitting driver 620 may be located on the other side of the display area DAA (e.g., in the first direction DR1, such as on the right side of the display area DAA). The scan lines GL may be electrically connected to either the scan driver 610 or the emission driver 620. For example, the first scan lines GWL, the second scan lines GCL, and the third scan lines GBL may be connected to the scan driver 610, and the emission control lines (EL1 and EL2) may be connected to the emission driver 620.

The second pad area PDA2 may be positioned on one side of the display area DAA with respect to the second direction DR2 (e.g., on the lower side of the display area DAA). A plurality of second pads PD2 may be located in the second pad area PDA2, and may be arranged in the first direction DR1. The second pads PD2 may be electrically connected to the first pads PD1 of the driving part 100, and the circuit board 300 may be attached over the second pads PD2. The second pads PD2 may be electrically connected to the circuit board 300, and may transmit electrical signals applied from the circuit board 300 to the driving part 100.

The display device 10 may include through holes (TSV1, TSV2, and TSV3), which form paths for electrically connecting the elements placed in the driving part 100 and the elements located in the display part 200. The through holes (TSV1, TSV2, and TSV3) may penetrate the second monocrystalline semiconductor substrate 210 of the display part 200. The drive circuit part 400 and data drive part 700, which are located in the driving part 100, may be electrically connected to the display part 200 and the circuit board 300 through connection lines located within the through holes (TSV1, TSV2, and TSV3).

The through holes (TSV1, TSV2, and TSV3) may include a plurality of first through holes TSV1, a plurality of second through holes TSV2, and a plurality of third through holes TSV3, which are located in the non-display area NA.

The first through holes TSV1 may be located on one side of the display area DAA within the non-display area NA. For example, the first through holes TSV1 may be located on the lower side of the display area DAA (e.g., in plan view). In some embodiments, the first through holes TSV1 may be located in the second pad area PDA2, and may be arranged not to overlap with the second pads PD2. The first through holes TSV1 may be located to correspond to the data lines DL, which are located in the display area DAA. The number of first through holes TSV1 may be equal to the number of data lines DL and the number of columns of subpixels (SP1, SP2, and SP3) in the display area DAA. The data lines DL may respectively correspond to the first through holes TSV1, and may be electrically connected to the connection lines within the first through holes TSV1. The subpixels (SP1, SP2, and SP3) may receive data signals from the data lines DL, which are connected to the driving part 100 through the first through holes TSV1.

The second through holes TSV2 may be located in the gate-driving part (610 and 620) in the non-display area NA. Some of the second through holes TSV2 may overlap with the scan driver 610, and other second through holes TSV2 may overlap with the emission driver 620. Connection lines that connect the gate-driving part (610 and 620) with the driving part 100 may be located in the second through holes TSV2, and signals for driving the gate-driving part (610 and 620) may be applied from the driving part 100 to the connection lines. For example, the gate-driving part (610 and 620) may be connected to connection lines that are linked to the drive circuit part 400 of the driving part 100 through the second through holes TSV2, and may receive timing signals applied to the gate-driving part (610 and 620).

The third through holes TSV3 may be located in the non-display area NA to overlap with the second pads PD2. The number of third through holes TSV3 may be equal to the number of second pads PD2. The second pads PD2 may be electrically connected to the first pads PD1 of the driving part 100 through the connection lines located within the third through holes TSV3.

FIG. 5 is a block diagram of a display device according to one or more embodiments of the present disclosure.

Referring to FIG. 5, the drive circuit part 400 may include a timing control circuit. Additionally, the drive circuit part 400 may further include various circuits involved in the operation of the display device 10, such as a gamma circuit and a logic circuit. The drive circuit part 400 may include drive circuit transistors formed on the first monocrystalline semiconductor substrate 110.

The drive circuit part 400 may receive digital video data and timing signals from an external source. The timing control circuit may generate a scan-timing control signal SCS, an emission-timing control signal ECS, and a data-timing control signal DCS according to the timing signals to control the display part 200. The timing control circuit may output the scan-timing control signal SCS to the scan driver of the gate-driving part 600, the emission-timing control signal ECS to the emission driver of the gate-driving part 600. The timing control circuit may output the digital video data and the data-timing control signal DCS to the data drive part 700.

A power supply unit may generate a plurality of panel driving voltages according to an external power voltage. For example, the power supply unit may generate a first driving voltage VSS, a second driving voltage VDD, a reference voltage VREF, and an initialization voltage VINT and may supply the first driving voltage VSS, the second driving voltage VDD, the reference voltage VREF, and the initialization voltage VINT to the pixels PX.

The scan-timing control signal SCS, the emission-timing control signal ECS, the digital video data DATA, and the data-timing control signal DCS from the drive circuit part 400 may be supplied to the pixels PX. The first driving voltage VSS, the second driving voltage VDD, the reference voltage VREF, and the initialization voltage VINT from the power supply unit may also be supplied to the pixels PX.

The gate-driving part (610 and 620) may include the scan driver 610 and the emission driver 620. The scan driver 610 may include a plurality of scan transistors formed on the second monocrystalline semiconductor substrate 210, and the emission driver 620 may include a plurality of emission transistors formed on the second monocrystalline semiconductor substrate 210. The scan transistors and the emission transistors may be formed through a semiconductor process. For example, the scan transistors and the emission transistors may be formed as CMOS transistors.

The scan driver 610 may include a first scan signal output portion 611, a second scan signal output portion 612, and a third scan signal output portion 613. The first scan signal output portion 611, the second scan signal output portion 612, and the third scan signal output portion 613 may receive the scan-timing control signal SCS from the drive circuit part 400. The first scan signal output portion 611 may generate write scan signals according to the scan-timing control signal SCS from the drive circuit part 400, and may sequentially output the write scan signals to the first scan lines GWL. The second scan signal output portion 612 may generate control scan signals according to the scan-timing control signal SCS, and may sequentially output the control scan signals to the second scan lines GCL. The third scan signal output portion 613 may generate bias scan signals according to the scan-timing control signal SCS, and may sequentially output the bias scan signals to the third scan lines GBL.

The emission driver 620 may include a first emission signal output portion 621 and a second emission signal output portion 622. The first emission signal output portion 621 and the second emission signal output portion 622 may receive the emission-timing control signal ECS from the drive circuit part 400. The emission driver 620 may generate emission control signals according to the emission-timing control signal ECS, and may sequentially output the emission control signals to first emission control lines EL1 and second emission control lines EL2.

The data drive part 700 may receive the digital video data DATA and the data-timing control signal DCS from the drive circuit part 400. The data drive part 700 may convert the digital video data DATA into analog data voltages according to the data-timing control signal DCS, and may output the analog data voltages to the data lines DL. In this case, the subpixels (SP1, SP2, and SP3) may be selected by the write scan signals from the scan driver 610, and the data voltages may be supplied to the selected subpixels (SP1, SP2, and SP3).

The pixels PX, the data lines DL, the scan lines GL, and the emission control lines EL may be located in the display area DAA of the display part 200. The scan lines GL may include the first scan lines GWL, the second scan lines GCL, and the third scan lines GBL. The scan lines GL and the emission control lines (EL1 and EL2) may extend in the first direction DR1, and may be spaced apart from one another in the second direction DR2. The data lines DL may extend in the second direction DR2, and may be spaced apart from one another in the first direction DR1.

FIG. 6 is an equivalent circuit diagram of a pixel according to one or more embodiments of the present disclosure.

Referring to FIG. 6, a subpixel SP1 may be connected to a first scan line GWL, a second scan line GCL, a third scan line GBL, a first emission control line EL1, a second emission control line EL2, and a data line DL. Additionally, the subpixel SP1 may be connected to a first driving voltage line VSL, to which a low potential voltage corresponding to the first driving voltage VSS is applied, a second driving voltage line VDL, to which a high potential voltage corresponding to the second driving voltage VDD is applied, and a third driving voltage line VIL, to which an initialization voltage corresponding to the third driving voltage VINT is applied. Thus, the first driving voltage line VSL may be a low potential voltage line, the second driving voltage line VDL may be a high potential voltage line, and the third driving voltage line VIL may be an initialization voltage line. In this case, the first driving voltage VSS may be lower than the third driving voltage VINT, and the second driving voltage VDD may be higher than the third driving voltage VINT.

The subpixel SP1 includes a plurality of first through sixth transistors T1, T2, T3, T4, T5, and T6, a light-emitting element LE, a first capacitor C1, and a second capacitor C2.

The light-emitting element LE emits light according to a drive current that flows through the channel of the first transistor T1. The amount of light emitted by the light-emitting element LE may be proportional to the drive current. The light-emitting element LE may be located between the fourth transistor T4 and the first driving voltage line VSL. The first electrode of the light-emitting element LE can be connected to the drain electrode of the fourth transistor T4, and the second electrode can be connected to the first driving voltage line VSL. The first electrode of the light-emitting element LE may be an anode, and the second electrode of the light-emitting element LE may be a cathode. The light-emitting element LE may be an organic light-emitting diode (LED) including a first electrode, a second electrode, and an organic light-emitting layer placed between the first and second electrodes, but the present disclosure is not limited thereto. Alternatively, the light-emitting element LE may be an inorganic light-emitting element including a first electrode, a second electrode, and an inorganic semiconductor located between the first and second electrodes, in which case, the light-emitting element LE may be a micro light-emitting diode (micro-LED).

The first transistor T1 may function as a drive transistor that controls a source-drain current or the drive current that flows between its source and drain electrodes according to the voltage applied to its gate electrode. The first transistor T1 includes a gate electrode connected to a first node N1, a source electrode connected to the drain electrode of the sixth transistor T6, and a drain electrode connected to a second node N2.

The second transistor T2 may be located between a first electrode of the first capacitor C1 and the data line DL. The second transistor T2 is turned on by a write scan signal from the first scan line GWL, connecting the first electrode of the first capacitor C1 to the data line DL. As a result, a data voltage from the data line DL may be applied to the first electrode of the first capacitor C1. The second transistor T2 includes a gate electrode connected to the first scan line GWL, a source electrode connected to the data line DL, and a drain electrode connected to the first electrode of the first capacitor C1.

The third transistor T3 may be located between the first and second nodes N1 and N2. The third transistor T3 is turned on by a write control signal from the second scan line GCL, thereby connecting the first node N1 to the second node N2. Consequently, the gate and source electrodes of the first transistor T1 are connected, allowing the first transistor T1 to operate as a diode. The third transistor T3 includes a gate electrode connected to the second scan line GCL, a source electrode connected to the second node N2, and a drain electrode connected to the first node N1.

The fourth transistor T4 may be connected between the second node N2 and a third node N3. The fourth transistor T4 is turned on by a first emission control signal from the first emission control line EL1, thereby connecting the second node N2 to the third node N3. Consequently, the drive current from the first transistor T1 may be applied to the light-emitting element LE. The fourth transistor T4 includes a gate electrode connected to the first emission control line EL1, a source electrode connected to the second node N2, and a drain electrode connected to the third node N3.

The fifth transistor T5 may be located between the third node N3 and the third driving voltage line VIL. The fifth transistor T5 is turned on by a bias scan signal from the third scan line GBL, thereby connecting the third node N3 to the third driving voltage line VIL. Consequently, an initialization voltage VINT from the third driving voltage line VIL may be applied to the first electrode of the light-emitting element LE. The fifth transistor T5 includes a gate electrode connected to the third scan line GBL, a source electrode connected to the third node N3, and a drain electrode connected to the third driving voltage line VIL.

The sixth transistor T6 may be located between the source electrode of the first transistor T1 and the second driving voltage line VDL. The sixth transistor T6 is turned on by a second emission control signal from the second emission control line EL2, thereby connecting the source electrode of the first transistor T1 to the second driving voltage line VDL. Consequently, the second driving voltage VDD from the second driving voltage line VDL may be applied to the source electrode of the first transistor T1. The sixth transistor T6 includes a gate electrode connected to the second emission control line EL2, a source electrode connected to the second driving voltage line VDL, and a drain electrode connected to the source electrode of the first transistor T1.

The first capacitor C1 is formed between the first node N1 and the drain electrode of the second transistor T2. The first capacitor C1 includes a first electrode connected to the drain electrode of the second transistor T2, and a second electrode connected to the first node N1.

The second capacitor C2 is formed between the gate electrode of the first transistor T1 and the second driving voltage line VDL. The second capacitor C2 includes a first electrode connected to the gate electrode of the first transistor T1, and a second electrode connected to the second driving voltage line VDL.

The first node N1 is the junction of the gate electrode of the first transistor T1, the drain electrode of the third transistor T3, the second electrode of the first capacitor C1, and the first electrode of the second capacitor C2. The second node N2 is the junction of the drain electrode of the first transistor T1, the source electrode of the third transistor T3, and the source electrode of the fourth transistor T4. The third node N3 is the junction of the drain electrode of the fourth transistor T4, the source electrode of the fifth transistor T5, and the first electrode of the light-emitting element LE.

The first through sixth transistors T1, T2, T3, T4, T5, and T6 may be MOSFETs. For example, the first through sixth transistors T1, T2, T3, T4, T5, and T6 may be P-type MOSFETs, but the present disclosure is not limited thereto. Alternatively, the first through sixth transistors T1, T2, T3, T4, T5, and T6 may be N-type MOSFETs. Yet alternatively, some of the first through sixth transistors T1, T2, T3, T4, T5, and T6 may be P-type MOSFETs, while the others may be N-type MOSFETs.

FIG. 6 illustrates that a subpixel SP includes six transistors (e.g., first through sixth transistors T1, T2, T3, T4, T5, and T6) and two capacitors (e.g., first and second capacitors C1 and C2), but the present disclosure is not limited thereto. That is, the numbers of transistors and capacitors included in each subpixel SP are not particularly limited.

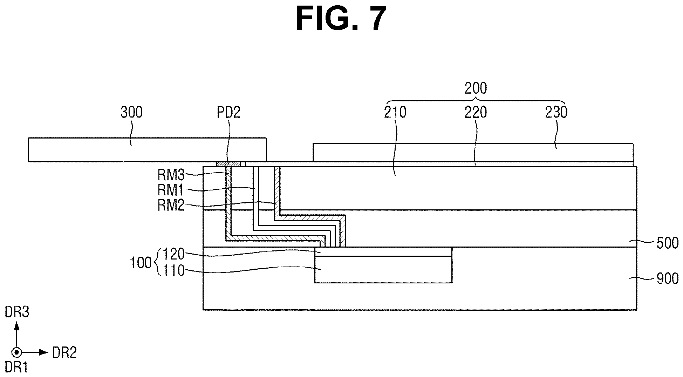

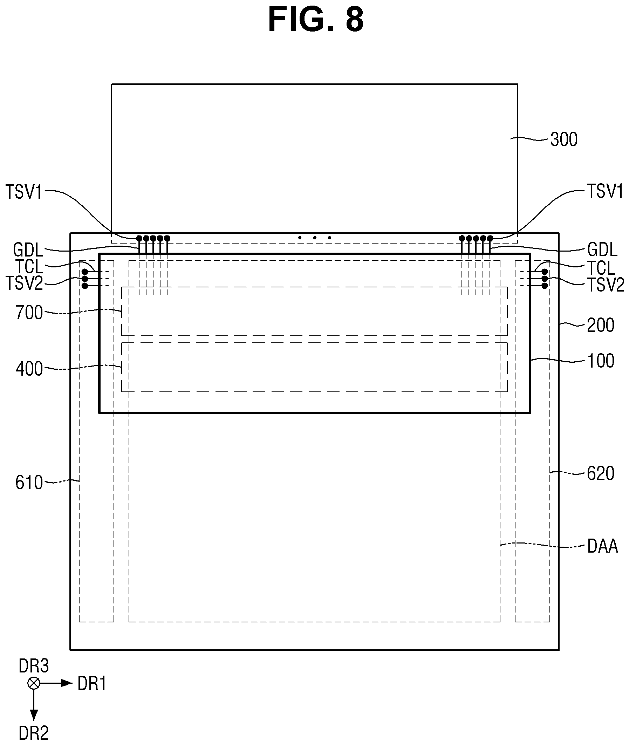

FIG. 7 is a cross-sectional view of the display device according to one or more embodiments of the present disclosure, and FIG. 8 is a bottom view of the display device according to one or more embodiments of the present disclosure. FIG. 7 illustrates the arrangement of routing wires (RM1, RM2, and RM3) that electrically connect the display part 200 and the driving part 100, and FIG. 8 illustrates the arrangement of the first through holes TSV1 and the second through holes TSV2 as viewed from the back side of the display device 10.

Referring to FIGS. 4, 7, and 8, the display device 10 may include the driving part 100, which includes the first monocrystalline semiconductor substrate 110 and a drive circuit layer 120 on the first monocrystalline semiconductor substrate 110, and the display part 200, which includes the second monocrystalline semiconductor substrate 210, a pixel circuit part 220, and a display element layer 230 on the second monocrystalline semiconductor substrate 210. The display device 10 may include two different monocrystalline semiconductor substrates (e.g., the first and second monocrystalline semiconductor substrates 110 and 210) that overlap in the third direction DR3, which is the thickness direction of the display device 10.

The driving part 100 may include circuit elements suitable for the emission of light-emitting elements included in the display element layer 230 of the display part 200. As mentioned earlier, the drive circuit layer 120 of the driving part 100 may include the drive circuit part 400 and the data drive part 700. The circuit elements that form the drive circuit part 400 and the data drive part 700, for example, transistors and capacitors, may be formed as CMOS transistors on the first monocrystalline semiconductor substrate 110.

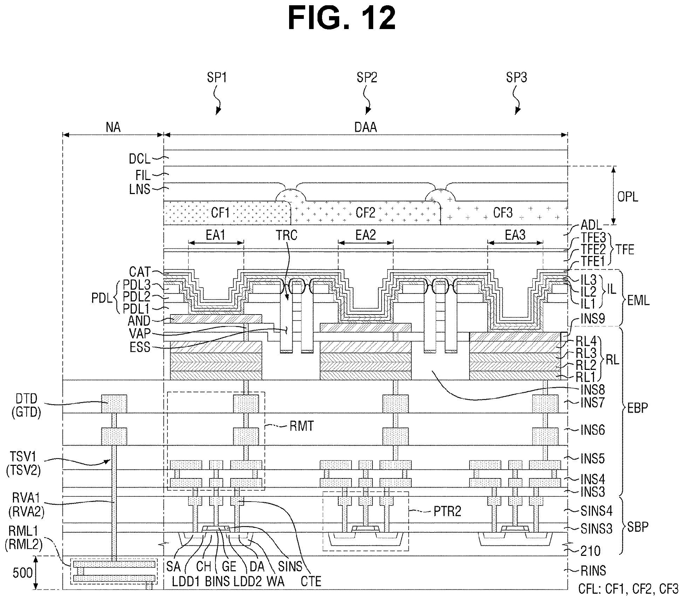

The display part 200 may include a plurality of light-emitting elements that emit light to display an image on the display device 10. The light-emitting elements may be electrically connected to the circuit elements formed in the driving part 100, and may thereby emit light. Additionally, the display part 200 may include the pixel circuit part 220, which accommodates the gate-driving part (610 and 620), as well as circuit elements and wirings that form the pixel circuits electrically connected to the subpixels (SP1, SP2, and SP3). The pixel circuit part 220 may include, as the circuit elements and the wirings, for example, the first through sixth transistors T1, T2, T3, T4, T5, and T6 of FIG. 6, the scan transistors that form the gate-driving part (610 and 620), the scan lines GL, and the data lines DL. The pixel circuit part 220 may also include a plurality of terminals (DTD and GTD) of FIG. 12, which are connected to the through holes (TSV1, TSV2, and TSV3) in the non-display area NA of the display part 200.

The protective layer 900 may be located around the driving part 100. The protective layer 900 may surround the driving part 100, and may be located on the bottom surface of the display part 200. The protective layer 900 may cover the driving part 100 during the fabrication of the display device 10, and may fill the step difference between the driving part 100 and the display part 200. When the first monocrystalline semiconductor substrate 110 is attached to the bottom surface of the second monocrystalline semiconductor substrate 210, which has a different area from the first monocrystalline semiconductor substrate 110, during the fabrication of the display device 10, the protective layer 900 may fill the step difference between the first and second monocrystalline semiconductor substrates 110 and 210 and may allow further processing to be performed on the second monocrystalline semiconductor substrate 210.

In one or more embodiments, the thickness of the protective layer 900 may be greater than the thickness of the first monocrystalline semiconductor substrate 110. The protective layer 900 may have a thickness equal to or greater than the combined thickness of the first monocrystalline semiconductor substrate 110 and the drive circuit layer 120 on the first monocrystalline semiconductor substrate 110. As the protective layer 900 is thicker than the driving part 100, part of the protective layer 900 may directly contact the bottom surface of the display part 200, and part of the protective layer 900 may directly contact the bottom surface of the driving part 100. Consequently, both the driving part 100 and the display part 200 may be completely covered by the protective layer 900, at the bottom surface of the display device 10.

Additionally, the protective layer 900 may have the same planar area as the second monocrystalline semiconductor substrate 210, and the sides of the protective layer 900 may be aligned with the sides of the second monocrystalline semiconductor substrate 210. The protective layer 900 may be split together with the second monocrystalline semiconductor substrate 210 when the second monocrystalline semiconductor substrate 210 is divided from a wafer substrate during the fabrication of the display device 10, and thus, the planar area of the protective layer 900 may be the same as the planar area of the second monocrystalline semiconductor substrate 210. Even though the display device 10 includes the first and second monocrystalline semiconductor substrates 110 and 210 with different planar areas, any partial step differences can all be compensated by the protective layer 900, ensuring structural stability.

The planar area of the driving part 100 or the first monocrystalline semiconductor substrate 110 may be smaller than the planar area of the display part 200 or the second monocrystalline semiconductor substrate 210. The transistors formed in the driving part 100 may be very small in size or linewidth, as they are formed through semiconductor microfabrication processes. The driving part 100 may accommodate a large number of circuit elements with high integration density, and may offer the advantage of reduced power consumption due to the miniaturization of the circuit elements.

Furthermore, as the driving part 100 includes only the CMOS elements formed on the first monocrystalline semiconductor substrate 110, but no light-emitting elements, it may be sufficient to secure space only for elements formed through microfabrication processes. It may still be adequate that the first monocrystalline semiconductor substrate 110 is smaller than the second monocrystalline semiconductor substrate 210, and thus, as a considerable number of driving parts 100 can be fabricated on a single wafer substrate, the manufacturing yield can be improved. For example, as the fabrication of each driving part 100 involves a high-cost semiconductor process, an improved manufacturing yield can also lead to a cost saving. Moreover, a large number of light-emitting elements can be formed on a relatively large second monocrystalline semiconductor substrate 210, enabling the implementation of a high-resolution display device.

The display device 10 may include a connection wiring layer 500, which is located between the second monocrystalline semiconductor substrate 210 of the display part 200 and the drive circuit layer 120 of the driving part 100. The connection wiring layer 500 may be located on the bottom surface of the second monocrystalline semiconductor substrate 210. The connection wiring layer 500 may include the routing wires (RM1, RM2, and RM3). The routing wires (RM1, RM2, and RM3) may connect the pixel circuit part 220 of the display part 200 and the circuit board 300 to the driving part 100. The drive circuit layer 120 of the driving part 100 may be electrically connected to the display part 200 and the circuit board 300 through the routing wires (RM1, RM2, and RM3) of the connection wiring layer 500 to transmit electrical signals for illumination.

First routing wires RM1 may be connected to the data lines DL in the display part 200 and the data drive part 700 in the driving part 100. The first routing wires RM1 may be located in the first through holes TSV1 that are formed in the second monocrystalline semiconductor substrate 210, and may include data routing wires GDL of the connection wiring layer 500. The first through holes TSV1 may be located in the non-display area NA of the display part 200, and may not overlap with the driving part 100 in the thickness direction of the display device 10.

In one or more embodiments, the first through holes TSV1 may be located in the second pad area PDA2 of the non-display area NA of the display part 200, and may overlap not with the driving part 100, but with the circuit board 300 in the thickness direction of the display device 10. Parts of the first routing wires RM1 may be located within the first through holes TSV1, and the data routing wires GDL may be located in the connection wiring layer 500 to connect the first through holes TSV1, which do not overlap with the driving part 100, and the data drive part 700. As mentioned earlier, the display part 200 may have a larger planar area than the driving part 100, and the driving part 100, which is located on the back surface of the display part 200, may partially not overlap with the non-display area NA of the display part 200. Consequently, the driving part 100 may not overlap with the through holes (TSV1, TSV2, and TSV3), which are located in the non-display area NA, and the routing wires (RM1, RM2, and RM3) may include wires connecting the through holes (TSV1, TSV2, and TSV3) and the driving part 100.

The number of the first through holes TSV1 may be equal to the number of columns of the subpixels (SP1, SP2, and SP3) in the display area DAA. For instance, if the subpixels (SP1, SP2, and SP3) are arranged in the first and second directions DR1 and DR2 within the display area DAA, and the number of subpixel columns arranged in the first direction DR1 is 4000, then the number of the first through holes TSV1 may also be 4000. The first through holes TSV1 may correspond one-to-one with the columns of the subpixels (SP1, SP2, and SP3) arranged in the first direction DR1, and may also correspond one-to-one with the data lines DL and the first routing wires RM1 arranged in the first direction DR1. One data line DL arranged in parallel to one subpixel column may be connected to the data drive part 700 through one first routing wire RM1 located in one first through hole TSV1. The numbers of first routing wires RM1 and first through holes TSV1 may be equal to the numbers of subpixel columns and data lines DL.

Moreover, the data lines DL may extend in the second direction DR2, and may be connected to the respective first through holes TSV1 in the non-display area NA without bending to maintain a substantially parallel alignment. The display device 10 may maintain a uniform spacing between the data lines DL in both the display area DAA and the non-display area NA of the display part 200, thereby eliminating the need for a fan-out structure where the data lines DL bend and become narrow in the non-display area NA. The spacings between the first through holes TSV1 and between the data routing wires GDL may also be maintained uniformly, similar to the spacing between the data lines DL. The driving part 100 of the display device 10 may have a width that allows the data lines DL and the data routing wires GDL to extend in parallel at intervals of an equal distance. For example, the width of the driving part 100 in the first direction DR1 may be greater than the width of the display area DAA in the first direction DR1. The display device 10 allows the data lines DL to be connected to the driving part 100 through the first through holes TSV1, and to be arranged in parallel without a fan-out structure, thereby reducing or minimizing interference between adjacent wirings.

Second routing wires RM2 may be connected to the gate-driving part (610 and 620), which is located in the display part 200, and to the drive circuit part 400, which is located in the driving part 100. The second routing wires RM2 may be located in the second through holes TSV2, which are formed in the second monocrystalline semiconductor substrate 210, and may include control routing wires TCL of the connection wiring layer 500. The second through holes TSV2 may be located in the non-display area NA of the display part 200, and may not overlap with the driving part 100 and the circuit board 300 in the thickness direction of the display device 10. In some embodiments, the second through holes TSV2 may overlap with each of the scan driver 610 and the emission driver 620.

Parts of the second routing wires RM2 may be located within the second through holes TSV2, and the control routing wires TCL may be located in the connection wiring layer 500 and may connect the second through holes TSV2, which do not overlap with the driving part 100, and the driving part 100.

The gate-driving part (610 and 620) may be electrically connected to the drive circuit part 400 of the driving part 100, and may receive timing control signals. Unlike the first through holes TSV1 and the first routing wires RM1, the second through holes TSV2 and the second routing wires RM2 may not be located to correspond one-to-one with the scan lines GL. In one or more embodiments, the numbers of second through holes TSV2 and second routing wires RM2 may be less than the numbers of first through holes TSV1 and first routing wires RM1.

Third routing wires RM3 may be connected to the second pads PD2 in the display part 200 and the first pads PD1 in the driving part 100. The third routing wires RM3 may be located in the third through holes TSV3, formed in the second monocrystalline semiconductor substrate 210. The third through holes TSV3 are arranged to overlap with the second pads PD2 and the circuit board 300 in the second pad area PDA2, and parts of the third routing wires RM3 may be located in the connection wiring layer 500, and may overlap with the driving part 100. The third routing wires RM3 may be wires transmitting signals applied from the circuit board 300 to the driving part 100.

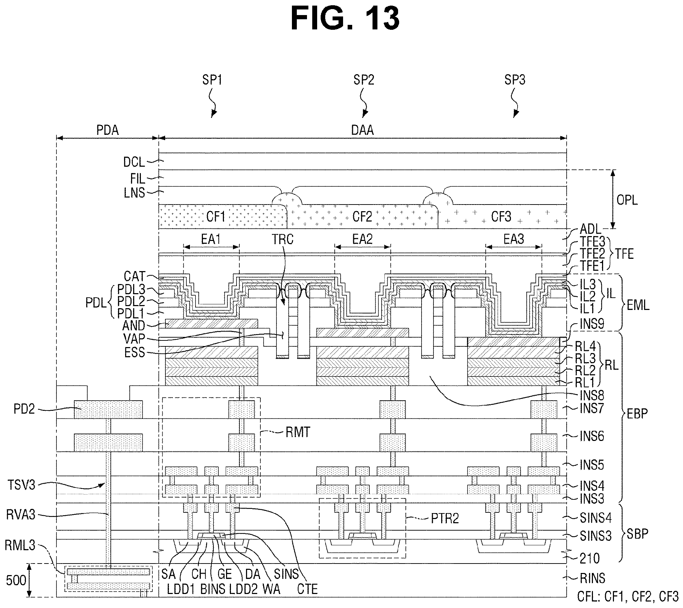

The routing wires (RM1, RM2, and RM3) may include connection wires (RML1, RML2, and RML3) of FIGS. 12 and 13, which are located in the connection wiring layer 500, and conductive vias (RVA1, RVA2, and RVA3) of FIGS. 12 and 13, which are located within the through holes (TSV1, TSV2, and TSV3) in the second monocrystalline semiconductor substrate 210. The routing wires (RM1, RM2, and RM3), which are wires electrically connecting the layers above the second monocrystalline semiconductor substrate 210 and the layers below the second monocrystalline semiconductor substrate 210. The arrangement and design of the through holes (TSV1, TSV2, and TSV3) in the second monocrystalline semiconductor substrate 210 may vary depending on the arrangement of the layers electrically connected to the routing wires (RM1, RM2, and RM3).

The driving part 100 of the display device 10 may have a smaller area than the display part 200, and may overlap partially with the display area DAA, but not with the through holes (TSV1, TSV2, and TSV3) in the non-display area NA. As a result, the driving part 100 may partially overlap with the connection wires (RML1, RML2, and RML3) of FIGS. 12 and 13, which are connected to the conductive vias (RVA1, RVA2, and RVA3) within the through holes (TSV1, TSV2, and TSV3). As illustrated in FIG. 8, the driving part 100 may partially overlap with the data routing wires GDL and the control routing wires TCL.

The display device 10 may include the driving part 100 and the display part 200, which include different monocrystalline semiconductor substrates (e.g., the first and second monocrystalline semiconductor substrates 110 and 210), and may also include the routing wires (RM1, RM2, and RM3), which connect the driving part 100 and the display part 200, and may define the through holes (TSV1, TSV2, and TSV3), in which the routing wires (RM1, RM2, and RM3) are located. The through holes (TSV1, TSV2, and TSV3) are located to penetrate the second monocrystalline semiconductor substrate 210 of the display part 200, thus allowing for a corresponding diameter and spacing (e.g., predetermined diameter and spacing). The drive circuit part 400, the gate-driving part (610 and 620), and the data drive part 700 may be appropriately distributed between the driving part 100 and the display part 200, and thus, the number of routing wires (RM1, RM2, and RM3) connecting the drive circuit part 400, the gate-driving part (610 and 620), and the data drive part 700 can be reduced or minimized. The number of through holes (TSV1, TSV2, and TSV3) can be reduced such that the through holes (TSV1, TSV2, and TSV3) can all be accommodated in the non-display area NA of the display part 200, thereby reducing or minimizing the area occupied by the through holes (TSV1, TSV2, and TSV3). Despite the limited area of the non-display area NA in the display device 10, the through holes (TSV1, TSV2, and TSV3) can still be arranged with a sufficient diameter and spacing due to their reduced number. Therefore, potential interferences between the routing wires (RM1, RM2, and RM3) within the through holes (TSV1, TSV2, and TSV3) can be reduced.

The structures of the drive circuit layer 120 of the driving part 100 and the display element layer 230 of the display part 200 will hereinafter be described.

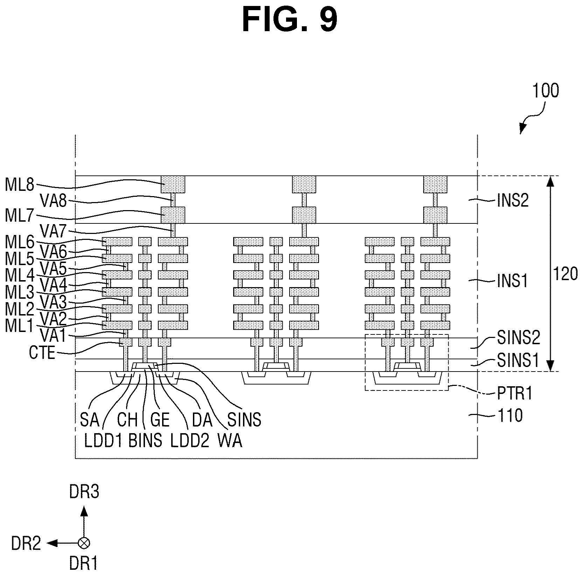

FIG. 9 is a cross-sectional view of a driving part according to one or more embodiments of the present disclosure.

Referring to FIG. 9, the driving part 100 may include the first monocrystalline semiconductor substrate 110, and the drive circuit layer 120, which is located on the first monocrystalline semiconductor substrate 110. FIG. 9 illustrates the cross-sectional structure of the data drive part 700 among the circuit parts located in the driving part 100.

The first monocrystalline semiconductor substrate 110 may be a Si, Ge, or SiGe substrate. The first monocrystalline semiconductor substrate 110 may be a substrate doped with first-type impurities. A plurality of well areas WA may be located on the top surface of the first monocrystalline semiconductor substrate 110. The well areas WA may be areas doped with second-type impurities. The second-type impurities may differ from the first-type impurities. For example, if the first-type impurities are p-type impurities, the second-type impurities may be n-type impurities. Alternatively, if the first-type impurities are n-type impurities, the second-type impurities may be p-type impurities.

Each of the well areas WA may include a source area SA, which corresponds to the source electrode of a first transistor PTR1, a drain area DA, which corresponds to the drain electrode of the first transistor PTR1, and a channel area CH, which is located between the source area SA and the drain area DA.

A bottom insulating film BINS may be located between gate electrodes GE of first transistors PTR1 and the well areas WA. Side insulating films SINS may be located on the sides of each of the gate electrodes GE. The side insulating films SINS may be located on the bottom insulating film BINS.

The source areas SA and the drain areas DA may be doped with the first-type impurities. The gate electrodes of first transistors PTR1 may overlap with the well areas WA in the third direction DR3. The channel areas CH may overlap with the gate electrodes GE in the third direction DR3. The source areas SA may be located on sides of the gate electrodes GE, and the drain areas SA may be located on other sides of the gate electrodes GE.

The well areas WA may further include first low-doped impurity areas LDD1, which are located between the channel areas CH and the source areas SA, and second low-doped impurity areas LDD2, which are located between the channel areas CH and the drain areas DA. The first low-doped impurity areas LDD1 may be areas with a lower impurity concentration than the source areas SA, due to the bottom insulating film BINS. Similarly, the second low-doped impurity areas LDD2 may be areas with a lower impurity concentration than the drain areas DA, also due to the bottom insulating film BINS. Due to the first low-doped impurity areas LDD1 and the second low-doped impurity areas LDD2, the distance between the source areas SA and the drain areas DA may increase. Consequently, as the length of the channel areas CH of the first transistors PTR1 increases, punch-throughs and a hot carrier phenomenon that may be caused by short channels can be reduced or prevented.

The first monocrystalline semiconductor substrate 110 may include a plurality of first transistors PTR1, which form the circuit elements in the driving part 100. The first transistors PTR1 formed on the first monocrystalline semiconductor substrate 110 may form the drive circuit part 400 or the data drive part 700.

Once the drive circuit layer 120 is formed on a Si wafer substrate, the first monocrystalline semiconductor substrate 110 may be thinned, and may be thinner than the Si wafer substrate where the formation of the drive circuit layer 120 has been performed. In some embodiments, the thickness of the first monocrystalline semiconductor substrate 110 may be less than about 100 µm, for example, in the range of about 80 µm to about 100 µm.

The drive circuit layer 120 may include a first semiconductor insulating layer SINS1, a second semiconductor insulating layer SINS2, a plurality of contact electrodes CTE, a first interlayer insulating layer INS1, a second interlayer insulating layer INS2, a plurality of conductive layers (ML1, ML2, ML3, ML4, ML5, ML6, ML7, and ML8), and a plurality of vias (VA1, VA2, VA3, VA4, VA5, VA6, VA7, and VA8). The drive circuit layer 120 may include wirings that are electrically connected to the first transistors PTR1 included in the first monocrystalline semiconductor substrate 110.

The first and second semiconductor insulating layers SINS1 and SINS2 may be located on the first monocrystalline semiconductor substrate 110. The first semiconductor insulating layer SINS1 is an insulating layer located on the first monocrystalline semiconductor substrate 110, and the second semiconductor insulating layer SINS2 may be an insulating layer located on the gate electrodes GE of the first transistors PTR1 and on the first semiconductor insulating layer SINS1. The first and second semiconductor insulating layers SINS1 and SINS2 may be formed as silicon carbonitride (SiCN)-based or silicon oxide (SiOₓ)-based inorganic films, but the present disclosure is not limited thereto. The first and second semiconductor insulating layers SINS1 and SINS2 are illustrated as being individual layers with a corresponding thickness, but the present disclosure is not limited thereto. The first and second semiconductor insulating layers SINS1 and SINS2 may have a structure where one or more layers are stacked on top of one another.

The contact electrodes CTE may be located on the first monocrystalline semiconductor substrate 110. The contact electrodes CTE may be connected to the gate electrodes GE, the source areas SA, or the drain areas DA of the first transistors PTR1, which are formed on the first monocrystalline semiconductor substrate 110, through holes that penetrate the first and second semiconductor insulating layers SINS1 and SINS2. The contact electrodes CTE may be formed of copper (Cu), aluminum (Al), tungsten (W), molybdenum (Mo), chromium (Cr), gold (Au), titanium (Ti), nickel (Ni), neodymium (Nd), or an alloy thereof. The top surfaces of the contact electrodes CTE may be exposed without being covered by the first and second semiconductor insulating layers SINS1 and SINS2.

The first interlayer insulating layer INS1 may be located on the contact electrodes CTE and the first and second semiconductor insulating layers SINS1 and SINS2. The second interlayer insulating layer INS2 may be located on the first interlayer insulating layer INS1. The first and second interlayer insulating layers INS1 and INS2 may be formed as SiCN-based or SiOₓ-based inorganic films, but the present disclosure is not limited thereto. The first and second interlayer insulating layers INS1 and INS2 are illustrated as being single layers with a corresponding thickness, but the present disclosure is not limited thereto. The first and second interlayer insulating layers INS1 and INS2 may have a structure where one or more layers are stacked on top of one another, and may be located between the conductive layers (ML1, ML2, ML3, ML4, ML5, ML6, ML7, and ML8) that will be described later.

The conductive layers (ML1, ML2, ML3, ML4, ML5, ML6, ML7, and ML8) and the vias (VA1, VA2, VA3, VA4, VA5, VA6, VA7, and VA8) may be electrically connected to the contact electrodes CTE and may form the drive circuit part 400 or the data drive part 700 of the driving part 100. The first transistors PTR1 formed on the first monocrystalline semiconductor substrate 110 may be electrically connected through the conductive layers (ML1, ML2, ML3, ML4, ML5, ML6, ML7, and ML8) and the vias (VA1, VA2, VA3, VA4, VA5, VA6, VA7, and VA8), forming the drive circuit part 400 and the data drive part 700 of the driving part 100.

First conductive layers ML1 may be connected to the contact electrodes CTE through first vias VA1. The first conductive layers ML1 are located on the contact electrodes CTE, and the first vias VA1 are located between, and in contact with, the first conductive layers ML1 and the contact electrodes CTE. Second conductive layers ML2 may be connected to the first conductive layers ML1 through second vias VA2. The second conductive layers ML2 are located on the first conductive layers ML1, and the second vias VA2 are located between, and in contact with, the first conductive layers ML1 and the second conductive layers ML2.

Third conductive layers ML3 may be connected to the second conductive layers ML2 through third vias VA3. Fourth conductive layers ML4 may be connected to the third conductive layers ML3 through fourth vias VA4, fifth conductive layers ML5 may be connected to the fourth conductive layers ML4 through fifth vias VA5, and sixth conductive layers ML6 may be connected to the fifth conductive layers ML5 through sixth vias VA6. The third conductive layers ML3, the fourth conductive layers ML4, the fifth conductive layers ML5, and the sixth conductive layers ML6 may be sequentially located on the second conductive layers ML2. The third vias VA3, the fourth vias VA4, the fifth vias VA5, and the sixth vias VA6 may be respectively located between the third conductive layers ML3, the fourth conductive layers ML4, the fifth conductive layers ML5, and the sixth conductive layers ML6. The third vias VA3, the fourth vias VA4, the fifth vias VA5, and the sixth vias VA6 may each contact different metal layers, positioned thereabove and therebelow. Seventh vias VA7 may be located on the sixth conductive layers ML6. The seventh vias VA7 may contact seventh conductive layers ML7, which are located on the seventh vias VA7, and the sixth conductive layers ML6.

The first conductive layers ML1, the second conductive layers ML2, the third conductive layers ML3, the fourth conductive layers ML4, the fifth conductive layers ML5, and the sixth conductive layers ML6 and the first vias VA1, the second vias VA2, the third vias VA3, the fourth vias VA4, the fifth vias VA5, the sixth vias VA6, and the seventh vias VA7 may be located on the first interlayer insulating layer INS1. The first conductive layers ML1, the second conductive layers ML2, the third conductive layers ML3, the fourth conductive layers ML4, the fifth conductive layers ML5, and the sixth conductive layers ML6 and the first vias VA1, the second vias VA2, the third vias VA3, the fourth vias VA4, the fifth vias VA5, the sixth vias VA6, and the seventh vias VA7 may form a first drive circuit layer in the first interlayer insulating layer INS1 of the drive circuit layer 120.

The seventh conductive layers ML7 may be connected to the sixth conductive layers ML6 through the seventh vias VA7. The seventh conductive layers ML7 are located on the first interlayer insulating layer INS1 and the sixth conductive layers ML6, and the seventh vias VA7 are located between, and are in contact with, the sixth conductive layers ML6 and the seventh conductive layers ML7. Eighth conductive layers ML8 may be connected to the seventh conductive layers ML7 through eighth vias VA8. The eighth conductive layers ML8 are located on the seventh conductive layers ML7, and the eighth vias VA8 are located between, and are in contact with, the seventh conductive layers ML7 and the eighth conductive layers ML8. The top surfaces of the eighth conductive layers ML8 may be exposed without being covered by the second interlayer insulating layer INS2, and may be electrically connected to the routing wires (RM1, RM2, and RM3), which are located in the display part 200.

The seventh conductive layers ML7, the eighth vias VA8, and the eighth conductive layers ML8 may be located in the second interlayer insulating layer INS2. The seventh conductive layers ML7, the eighth vias VA8, and the eighth conductive layers ML8 may form a second drive circuit layer in the second interlayer insulating layer INS2 of the drive circuit layer 120.

The conductive layers (ML1, ML2, ML3, ML4, ML5, ML6, ML7, and ML8) and the vias (VA1, VA2, VA3, VA4, VA5, VA6, VA7, and VA8) are illustrated as being sequentially stacked, alternating with one another, but the arrangement of the conductive layers (ML1, ML2, ML3, ML4, ML5, ML6, ML7, and ML8) and the vias (VA1, VA2, VA3, VA4, VA5, VA6, VA7, and VA8) may vary depending on the designs of the drive circuit part 400 and the data drive part 700 in the driving part 100. The connection structure illustrated in FIG. 9 is merely an example, and the connections within the drive circuit layer 120 of the driving part 100 of the display device 10 are not particularly limited. Alternatively, the drive circuit layer 120 may not include the conductive layers (ML1, ML2, ML3, ML4, ML5, ML6, ML7, and ML8) and the vias (VA1, VA2, VA3, VA4, VA5, VA6, VA7, and VA8). Yet alternatively, some of the conductive layers (ML1, ML2, ML3, ML4, ML5, ML6, ML7, and ML8) may be omitted, or additional conductive layers may be further located.

The conductive layers (ML1, ML2, ML3, ML4, ML5, ML6, ML7, and ML8) and the vias (VA1, VA2, VA3, VA4, VA5, VA6, VA7, and VA8) may be formed of substantially the same material. For example, the conductive layers (ML1, ML2, ML3, ML4, ML5, ML6, ML7, and ML8) and the vias (VA1, VA2, VA3, VA4, VA5, VA6, VA7, and VA8) may be formed of Cu, Al, W, Mo, Cr, Au, Ti, Ni, Nd, or an alloy thereof.

The thicknesses of the first conductive layers ML1, the second conductive layers ML2, the third conductive layers ML3, the fourth conductive layers ML4, the fifth conductive layers ML5, and the sixth conductive layers ML6 may be greater than the thicknesses of the first vias VA1, the second vias VA2, the third vias VA3, the fourth vias VA4, the fifth vias VA5, and the sixth vias VA6. The thicknesses of the second conductive layers ML2, the third conductive layers ML3, the fourth conductive layers ML4, the fifth conductive layers ML5, and the sixth conductive layers ML6 may be greater than the thickness of the first conductive layers ML1. The thicknesses of the second conductive layers ML2, the third conductive layers ML3, the fourth conductive layers ML4, the fifth conductive layers ML5, and the sixth conductive layers ML6 may be substantially the same. For example, the thickness of the first conductive layers ML1 may be approximately 1360 Å, the thicknesses of the second conductive layers ML2, the third conductive layers ML3, the fourth conductive layers ML4, the fifth conductive layers ML5, and the sixth conductive layers ML6 may be approximately 1440 Å, and the thicknesses of the first vias VA1, the second vias VA2, the third vias VA3, the fourth vias VA4, the fifth vias VA5, and the sixth vias VA6 may be approximately 1150 Å.

The thicknesses of the seventh conductive layers ML7 and the eighth conductive layers ML8 may be greater than the thicknesses of the first conductive layers ML1, the second conductive layers ML2, the third conductive layers ML3, the fourth conductive layers ML4, the fifth conductive layers ML5, and the sixth conductive layers ML6. The thicknesses of the seventh conductive layers ML7 and the eighth conductive layers ML8 may be greater than the thicknesses of the seventh vias VA7 and the eighth vias VA8. The thicknesses of the seventh vias VA7 and the eighth vias VA8 may be greater than the thicknesses of the first vias VA1, the second vias VA2, the third vias VA3, the fourth vias VA4, the fifth vias VA5, and the sixth vias VA6. The thicknesses of the seventh conductive layers ML7 and the eighth conductive layers ML8 may be substantially the same. For example, the thicknesses of the seventh conductive layers ML7 and the eighth conductive layers ML8 may both be approximately 9000 Å.The thicknesses of the seventh vias VA7 and the eighth vias VA8 may both be approximately 6000 Å.

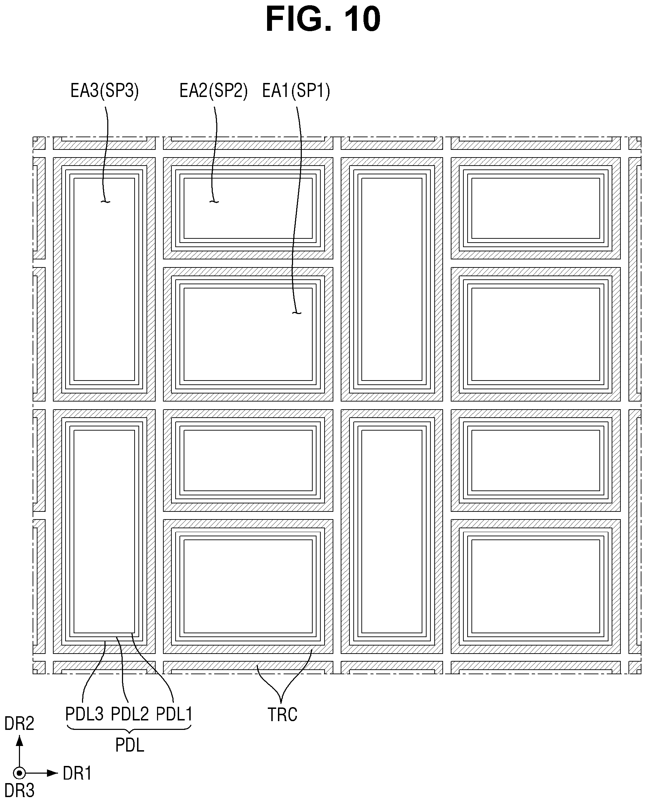

FIG. 10 is a plan view illustrating the first electrodes, light-emitting areas, and pixel-defining films of multiple subpixels arranged in the display area of a display part according to one or more embodiments of the present disclosure.

Referring to FIG. 10, each of multiple pixels PX may include first, second, and third subpixels SP1, SP2, and SP3. Each of the first, second, and third subpixels SP1, SP2, and SP3 may include a light-emitting area. For example, the first subpixel SP1 may include a first light-emitting area EA1, the second subpixel SP2 may include a second light-emitting area EA2, and the third subpixel SP3 may include a third light-emitting area EA3.

The first, second, and third light-emitting areas EA1, EA2, and EA3 may have a rectangular shape, such as a square or rhombus shape, in plan view. For example, the first light-emitting area EA1 may have a rectangular planar shape with short sides in the first direction DR1 and long sides in the second direction DR2. Similarly, the second light-emitting area EA2 and the third light-emitting areas EA3 may have a rectangular planar shape with long sides in the first direction DR1 and short sides in the second direction DR2.

The first, second, and third light-emitting areas EA1, EA2, and EA3 may be defined by pixel-defining films PDL. For example, each of the first, second, and third light-emitting areas EA1, EA2, and EA3 may be defined by a first pixel-defining film PDL1.

The length of the third light-emitting area EA3 in the first direction DR1 may be less than the length of the first light-emitting area EA1 in the first direction DR1, and may also be less than the length of the second light-emitting area EA2 in the first direction DR1. The lengths of the first and second light-emitting areas EA1 and EA2 in the first direction DR1 may be substantially the same.

In each pixel PX, the first and second light-emitting areas EA1 and EA2 may be adjacent to each other in the second direction DR2, the first and third light-emitting areas EA1 and EA3 may be adjacent to each other in the first direction DR1, and the second and third light-emitting areas EA2 and EA3 may be adjacent to each other in the first direction DR1. The areas of the first, second, and third light-emitting areas EA1, EA2, and EA3 may all differ.

The first, second, and third light-emitting areas EA1, EA2, and EA3 are illustrated as having a rectangular planar shape, but the present disclosure is not limited thereto. Alternatively, the first, second, and third light-emitting areas EA1, EA2, and EA3 may have various other planar shapes, such as a non-rectangular polygonal shape, a circular shape, or an elliptical shape.

The first light-emitting area EA1 may emit first-color light, the second light-emitting area EA2 may emit second-color light, and the third light-emitting area EA3 may emit third-color light. Here, the first-color light may be red-wavelength light, the second-color light may be green-wavelength light, and the third-color light may be blue-wavelength light. For example, the blue-wavelength light may refer to light whose main peak wavelength ranges from about 370 nm to about 460 nm, the green-wavelength light may refer to light whose main peak wavelength ranges from about 480 nm to about 560 nm, and the red-wavelength light may refer to light whose main peak wavelength ranges from about 600 nm to about 750 nm.

A first electrode AND of each light-emitting element may have a rectangular planar shape. The planar shape of the first electrode AND may differ between the first, second, and third subpixels SP1, SP2, and SP3. For example, the first electrodes AND of the first and second subpixels SP1 and SP2 may have a rectangular planar shape with long sides in the first direction DR1 and short sides in the second direction DR2. The first electrode AND of the third subpixel SP3 may have a rectangular planar shape with short sides in the first direction DR1 and long sides in the second direction DR2. The length of the first electrode AND of the third subpixel SP3 in the first direction DR1 may be less than the lengths of the first electrodes AND of the first and second subpixels SP1 and SP2 in the second direction DR2. The length of the first electrode AND of the first subpixel SP1 in the second direction DR2 may be greater than the length of the second subpixel SP2 in the second direction DR2.

The first electrode AND of each light-emitting element may be connected to a reflective electrode layer RL of FIG. 12 through an electrode via VAP. The electrode via VAP may overlap with the first pixel-defining film PDL1, a second pixel-defining film PDL2, and a third pixel-defining film PDL3 in the third direction DR3.

One or more trenches TRC may be structures for interrupting at least one charge-generating layer of each light-emitting stack IL between neighboring light-emitting areas (EA1, EA2, and EA3). The trenches TRC may be located between the first and second light-emitting areas EA1 and EA2, between the first and third light-emitting areas EA1 and EA3, and between the second and third light-emitting areas EA2 and EA3. For example, the trenches TRC may be located between the first electrode AND of the first subpixel SP1 and the first electrode AND of the second subpixel SP2, between the first electrode AND of the first subpixel SP1 and the first electrode AND of the third subpixel SP3, and between the first electrode AND of the second subpixel SP2 and the first electrode AND of the third subpixel SP3.

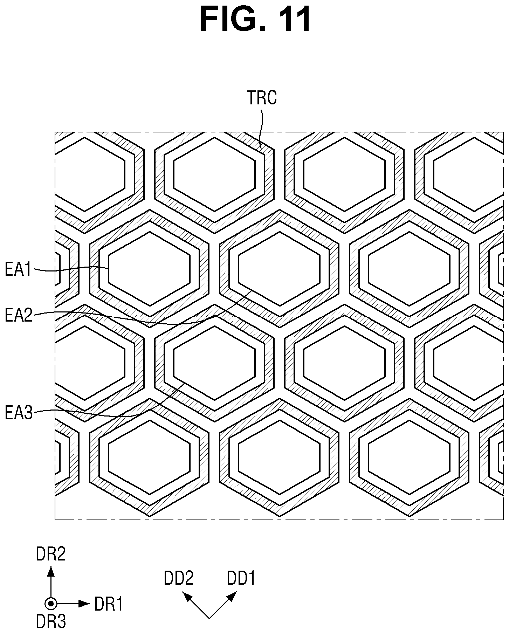

FIG. 11 is a plan view illustrating the first electrodes, light-emitting areas, and pixel-defining films of multiple subpixels arranged in the display area of a display part according to one or more other embodiments of the present disclosure.

The one or more embodiments corresponding to FIG. 11 is substantially the same as the one or more embodiments corresponding to FIG. 10 except that the planar shapes of first light-emitting areas EA1, second light-emitting areas EA2, and third light-emitting areas EA3, and thus will hereinafter be described, focusing mainly on the differences from the one or more embodiments corresponding to FIG. 10.

The first light-emitting areas EA1, the second light-emitting areas EA2, and the third light-emitting areas EA3 may have a hexagonal planar shape and may be arranged in a hexagonal structure. In this case, the first light-emitting areas EA1 and the second light-emitting areas EA2 may be adjacent to one another in a first direction DR1, and the second light-emitting areas EA2 and the third light-emitting areas EA3 may be adjacent to one another in a first diagonal direction DD1, and the first light-emitting areas EA1 and the third light-emitting areas EA3 may be adjacent to one another in a second diagonal direction DD2. The first diagonal direction DD1 refers to a direction between the first direction DR1 and a second direction DR2, for example, a direction at an inclination of 45 degrees relative to the first and second directions DR1 and DR2, and the second diagonal direction DD2 may be orthogonal to the first diagonal direction DD1.

FIGS. 10 and 11 illustrate that each pixel PX includes three light-emitting areas (e.g., first, second, and third light-emitting areas EA1, EA2, and EA3), but the present disclosure is not limited thereto. Alternatively, each pixel PX may include four light-emitting areas.

Moreover, the arrangement of the light-emitting areas of each pixel PX is not particularly limited to that illustrated in FIG. 11. Alternatively, the light-emitting areas of each pixel PX may be arranged in various other structures, such as a stripe structure where the light-emitting areas are arranged along the first direction DR1, a PenTile^{®} structure where the light-emitting areas are arranged in a diamond fashion, or a hexagonal structure where the light-emitting areas with a hexagonal planar shape are arranged (PenTile^{®} and PENTILE^{™} being registered trademarks of Samsung Display Co., Ltd., Republic of Korea).

FIGS. 12 and 13 are cross-sectional views illustrating parts of the display and non-display areas of the display part according to one or more embodiments of the present disclosure. FIGS. 12 and 13 illustrate the schematic cross-sectional structures of the display area DAA, the non-display area NA, and the pad area PDA.

Referring to FIGS. 12 and 13, the display part 200 may include a semiconductor backplane SBP, an emitter backplane EBP, a light-emitting element layer EML, an encapsulation layer TFE, an adhesive layer ADL, a color filter layer CFL, lenses LNS, and a cover layer DCL. In one or more embodiments, the display part 200 may further include a polarizer plate, which is located on the cover layer DCL. The connection wiring layer 500 may be located between the second monocrystalline semiconductor substrate 210 of the semiconductor backplane SBP and the first monocrystalline semiconductor substrate 110. Alternatively, the connection wiring layer 500 may be located between the light-emitting element layer EML and the first monocrystalline semiconductor substrate 110.

The semiconductor backplane SBP includes the second monocrystalline semiconductor substrate 210, which includes a plurality of second transistors PTR2, a plurality of semiconductor insulating films, which are located on the second transistors PTR2, and a plurality of contact electrodes CTE, which are electrically connected to pixel transistors. The second transistors PTR2 may correspond to the first through sixth transistors T1, T2, T3, T4, T5, and T6 of FIG. 6 or the scan transistors of the gate-driving part (610 and 620).

The second monocrystalline semiconductor substrate 210 may be a Si, Ge, or SiGe substrate. The second monocrystalline semiconductor substrate 210 may be a substrate doped with impurities. A plurality of well areas WA may be located on the top surface of the second monocrystalline semiconductor substrate 210. The well areas WA may be doped with the second-type impurities. The second-type impurities may be different from the first-type impurities. For example, if the first-type impurities are p-type impurities, the second-type impurities may be n-type impurities. Alternatively, if the first-type impurities are n-type impurities, the second-type impurities may be p-type impurities.

The second monocrystalline semiconductor substrate 210, similarly to the first monocrystalline semiconductor substrate 110, may include a plurality of second transistors PTR2. The structure of the second transistors PTR2 may be identical to the structure of the first transistors PTR1, and thus, a detailed description thereof will be omitted.

A first wafer substrate where the first transistors PTR1 on the first monocrystalline semiconductor substrate 110 of the driving part 100 are formed may differ from a second wafer substrate where the second transistors PTR2 on the second monocrystalline semiconductor substrate 210 of the display part 200. The size and linewidth of the first transistors PTR1 formed on the first monocrystalline semiconductor substrate 110 may differ from the size and linewidth of the second transistors PTR2 formed on the second monocrystalline semiconductor substrate 210.

For example, the minimum linewidth of the first transistors PTR1 formed on the first monocrystalline semiconductor substrate 110 may be less than the minimum linewidth of the second transistors PTR2 formed on the second monocrystalline semiconductor substrate 210. The semiconductor process performed on the first wafer substrate for forming the first transistors PTR1 may have a higher resolution than the semiconductor process performed on the second wafer substrate for forming the second transistors PTR2. As a result, smaller devices, such as transistors, may be formed on the first wafer substrate than on the second wafer substrate. In other words, the semiconductor process performed on the first wafer substrate may be finer than the semiconductor process performed on the second wafer substrate.

As mentioned above, the first monocrystalline semiconductor substrate 110 of the driving part 100 may have a smaller planar area than the second monocrystalline semiconductor substrate 210 of the display part 200, and small-sized devices may be arranged on the first monocrystalline semiconductor substrate 110 with high integration density, thereby reducing power consumption and improve manufacturing yield. On the other hand, the second monocrystalline semiconductor substrate 210 of the display part 200 can have a larger planar area than the first monocrystalline semiconductor substrate 110, and processes with relatively larger linewidths can be performed on the second monocrystalline semiconductor substrate 210. The second transistors PTR2, which form pixel circuits, may be formed over a larger area on the second monocrystalline semiconductor substrate 210 than on the first monocrystalline semiconductor substrate 110, and may not require high integration density. Therefore, semiconductor processes performed can be performed on the first wafer substrate as high-cost processes with relatively smaller linewidths, and on the second wafer substrate as low-cost processes with relatively larger linewidths.

The length of the channel areas CH of the first transistors PTR1 may differ from the length of the channel areas CH of the second transistors PTR2. For example, the minimum linewidth of the first transistors PTR1, or the length of the channel areas CH of the first transistors PTR1, may be less than the minimum linewidth of the second transistors PTR2, or the length of the channel areas CH of the second transistors PTR2. The minimum linewidth of the first transistors PTR1 or the length of the channel areas CH of the first transistors PTR1 may be 100 nm or less or in the range of about 2 nm to about 80 nm. The minimum linewidth of the second transistors PTR2 or the length of the channel areas CH of the second transistors PTR2 may be about 100 nm or greater or in the range of about 100 nm to about 5 µm.

The second monocrystalline semiconductor substrate 210 may include the through holes (TSV1, TSV2, and TSV3). The through holes (TSV1, TSV2, and TSV3) penetrate from the top surface to the bottom surface of the second monocrystalline semiconductor substrate 210, and may also penetrate third and fourth semiconductor insulating layers SINS3 and SINS4 and third, fourth, and fifth interlayer insulating layers INS3, INS4, and INS5, which are located on the second monocrystalline semiconductor substrate 210. Conductive vias (RVA1, RVA2, and RVA3) of the routing wires (RM1, RM2, and RM3) may be located in the through holes (TSV1, TSV2, and TSV3). The through holes (TSV1, TSV2, and TSV3) may form connection passages for the routing wires (RM1, RM2, and RM3) that electrically connect the driving part 100 and the pixel circuit part 220 and the second pads PD2 of the display part 200. In some embodiments, the through holes (TSV1, TSV2, and TSV3) in the second monocrystalline semiconductor substrate 210 may be formed through a through silicon via (TSV) process that forms holes penetrating a wafer substrate. Through the through holes (TSV1, TSV2, and TSV3) formed in the second monocrystalline semiconductor substrate 210, the display element layer 230 and the driving part 100 may be electrically connected to each other through the routing wires (RM1, RM2, and RM3) without separate wires.

The second monocrystalline semiconductor substrate 210 may be thinned after the bonding of the driving part 100 on a Si wafer substrate, and may thus be thinner than the wafer substrate where the processes of forming conductive layers are performed. In some embodiments, the thickness of the second monocrystalline semiconductor substrate 210 may be less than about 100 µm, for example, in the range of about 80 µm to about 100 µm.

The pixel circuit part 220 may be located on the second monocrystalline semiconductor substrate 210. The pixel circuit part 220 may include parts of the semiconductor backplane SBP and the emitter backplane EBP.

The third semiconductor insulating film SINS3 may be located on the second monocrystalline semiconductor substrate 210. The third semiconductor insulating film SINS3 may be formed as SiCN-based or SiOₓ-based inorganic films, but the present disclosure is not limited thereto.

The fourth semiconductor insulating film SINS4 may be located on the third semiconductor insulating film SINS3. The fourth semiconductor insulating film SINS4 may be formed as a SiOₓ-based inorganic film, but the present disclosure is not limited thereto.

The contact electrodes CTE may be connected to gate electrodes GE, source areas SA, or drain areas DA of the second transistors PTR2 through holes penetrating the third semiconductor insulating film SINS3 and the fourth interlayer insulating layer INS4. The contact electrodes CTE may be formed of Cu, Al, W, Mo, Cr, Au, Ti, Ni, Nd, or an alloy thereof.

The emitter backplane EBP may include third through seventh interlayer insulating layers INS3, INS4, INS5, INS6, and INS7 and a plurality of routing conductive layers RMT. The routing conductive layers RMT may include wirings electrically connected to the second transistors PTR2 on the second monocrystalline semiconductor substrate 210, and may also include the scan lines GL, the data lines DL, and a plurality of terminals (DTD and GDT), which are located in the display part 200.

The third interlayer insulating layer INS3 may be located on the contact electrodes CTE and the third and fourth semiconductor insulating films SINS3 and SINS4. The fourth interlayer insulating layer INS4 may be located on the third interlayer insulating layer INS3. The fifth, sixth, and seventh interlayer insulating layers INS5, INS6, and INS7 may be sequentially located on the fourth interlayer insulating layer INS4. The routing conductive layers RMT may be located between the fifth, sixth, and seventh interlayer insulating layers INS5, INS6, and INS7. The third through seventh interlayer insulating layers INS3, INS4, INS5, INS6, and INS7 may be formed as SiCN-based or SiOₓ-based inorganic films, but the present disclosure is not limited thereto. The third through seventh interlayer insulating layers INS3, INS4, INS5, INS6, and INS7 are illustrated as being single layers, but the present disclosure is not limited thereto. The third through seventh interlayer insulating layers INS3, INS4, INS5, INS6, and INS7 may have a structure where one or more layers are stacked on one another, and may be located between a plurality of conductive layers (ML1, ML2, ML3, ML4, ML5, ML6, ML7, and ML8) that will be described later.

The routing conductive layers RMT may include a structure analogous to the conductive layers (ML1, ML2, ML3, ML4, ML5, ML6, ML7, and ML8) and vias (VA1, VA2, VA3, VA4, VA5, VA6, VA7, and VA8) in the drive circuit layer 120. The routing conductive layers RMT may include one or more conductive layers and vias located between the conductive layers, forming connections or the terminals (DTD and GTD) within the display part 200. For example, the routing conductive layers RMT, which are located in the display area DAA of the pixel circuit part 220, may be electrically connected to the second transistors PTR2. The routing conductive layers RMT may be connected to the second transistors PTR2 and may form the pixel circuits as illustrated in FIG. 6. The routing conductive layers RMT may serve as connection wirings that connect the second transistors (PTR2) to circuit components. Additionally, in one or more embodiments, some of the routing conductive layers RMT located in the display area DAA of the pixel circuit part 220 may function as the scan lines GL, the data lines DL, or the connecting wirings that form the gate-driving part (610 and 620).

The pixel circuit part 220 may include the terminals (DTD and GTD), which are located in the non-display area NA. The terminals (DTD and GTD) may include data terminals DTD, which are electrically connected to the data lines DL, and gate terminals GTD, which are connected to the gate-driving part (610 and 620). The data terminals DTD may be electrically connected to the data lines DL and the first wires RM1, and the gate terminals GTD may be electrically connected to the gate-driving part (610 and 620) and the second routing wires RM2.

The connection wiring layer 500 may be located on the bottom surface of the second monocrystalline semiconductor substrate 210. The connection wiring layer 500 may include an interlayer insulating layer RINS and a plurality of connection wires (RML1, RML2, and RML3).

The interlayer insulating layer RINS may be located on the bottom surface of, or below, the second monocrystalline semiconductor substrate 210. The interlayer insulating layer RINS may be formed as a SiCN-based or SiOₓ-based inorganic film, the present disclosure is not limited thereto. The interlayer insulating layer RINS is illustrated as being a single layer, but the present disclosure is not limited thereto. Alternatively, the interlayer insulating layer RINS may have a structure where one or more layers are stacked on each other and may be located between the connection wires (RML1, RML2, and RML3).

The connection wires (RML1, RML2, and RML3) may form the routing wires (RM1, RM2, and RM3) together with the conductive vias (RVA1, RVA2, and RVA3). The connection wires (RML1, RML2, and RML3) may include one or more conductive layers and vias connecting the conductive layers. The connectivity and structure of the connection wires (RML1, RML2, and RML3) may be similar to those of the conductive layers (ML1, ML2, ML3, ML4, ML5, ML6, ML7, and ML8) and the vias (VA1, VA2, VA3, VA4, VA5, VA6, VA7, and VA8) described earlier. The connection wires (RML1, RML2, and RML3) may be electrically connected to the pixel circuit part 220 or the second pads PD2 through the conductive vias (RVA1, RVA2, and RVA3), which are located in the through holes (TSV1, TSV2, and TSV3) of the second monocrystalline semiconductor substrate 210, and may be electrically connected to the drive circuit layer 120 of the driving part 100.

The display part 200 of the display device 10 may include first through holes TSV1, second through holes TSV2, and third through holes TSV3, which all penetrate the second monocrystalline semiconductor substrate 210. The first through holes TSV1, the second through holes TSV2, and the third through holes TSV3 may all be located in the non-display area NA. As mentioned earlier, the first through holes TSV1 and the third through holes TSV3 may be located in the pad area PDA of the display part 200, and the second through holes TSV2 may be located in the non-display area NA to overlap with the gate-driving part (610 and 620).

The first routing wires RM1, which connect the data terminals DTD, linked to the data lines DL, and the drive circuit layer 120 of the driving part 100, may be located in the first through holes TSV1. The first through holes TSV1 may penetrate the second monocrystalline semiconductor substrate 210, the third and fourth semiconductor insulating layers SINS3 and SINS4, and the third, fourth, and fifth interlayer insulating layers INS3, INS4, and INS5, from the bottom surfaces of the data terminals DTD to the bottom surface of the second monocrystalline semiconductor substrate 210. First conductive vias RVA1 may be located from the bottom surfaces of the data terminals DTD to the bottom surface of the second monocrystalline semiconductor substrate 210, and may thereby be connected to the data terminals DTD and the first connection wires RML1. The first connection wires RML1 may be the data routing wires GDL of FIG. 8.

The second routing wires RM2, which connect the gate terminals GTD, linked to the gate-driving part (610 and 620), and the drive circuit layer 120 of the driving part 100, may be located in the second through holes TSV2. The second through holes TSV2 may penetrate the second monocrystalline semiconductor substrate 210, the third and fourth semiconductor insulating layers SINS3 and SINS4, and the third, fourth, and fifth interlayer insulating layers INS3, INS4, and INS5, from the bottom surfaces of the gate terminals GTD to the bottom surface of the second monocrystalline semiconductor substrate 210. Second conductive vias RVA2 may be located from the bottom surfaces of the gate terminals GTD to the bottom surface of the second monocrystalline semiconductor substrate 210, and may thereby be connected to the gate terminals GTD and the second connection wires RML2. The second connection wires RML2 may be the control routing wires TCL of FIG. 8.

The through holes and the conductive vias located in the non-display area NA of FIG. 12 may be the first or second through holes TSV1 or TSV2 and the first or second conductive vias RVA1 or RVA2, respectively. The terminals depicted in FIG. 12 may be the data terminals DTD or the gate terminals GTD. The first routing wires RM1 and the second routing wires RM2, as well as the first through holes TSV1 and the second through holes TSV2, may have similar cross-sectional structures, and may differ only in their placement, quantity, and connectivity.

The third routing wires RM3, which may connect the second pads PD2 in the pad area PDA of the display part 200 with the first pads PD1 of the driving part 100, may be located in the third through holes TSV3. The third through holes TSV3 may penetrate the second monocrystalline semiconductor substrate 210, the third and fourth semiconductor insulating layers SINS3 and SINS4, and the third, fourth, and fifth interlayer insulating layers INS3, INS4, and INS5, from the bottom surfaces of the second pads PD2 to the bottom surface of the second monocrystalline semiconductor substrate 210. Third conductive vias RVA3 may be located from the bottom surfaces of the second pads PD2 to the bottom surface of the second monocrystalline semiconductor substrate 210, and may thereby be connected to the second pads PD2 and the third connection wires RML3.

By forming the circuit parts in the driving part 100 using high-cost, fine semiconductor processes, high integration density can be achieved on the first monocrystalline semiconductor substrate 110, which has a relatively smaller area. The fabrication of the driving part 100 can yield high output per wafer substrate, and circuit components (e.g., first transistors) can be of small size, thereby reducing power consumption. Furthermore, by placing pixel circuits for the emission of light-emitting elements, some circuit components, and wirings on the display part 200, excessive integration density on the first monocrystalline semiconductor substrate 110 can be mitigated. Additionally, by improving or optimizing the number of through holes (TSV1, TSV2, and TSV3), where the routing wires (RM1, RM2, and RM3) are located, the space suitable for the placement of the through holes (TSV1, TSV2, and TSV3) with the corresponding diameter and spacing design can be reduced or minimized.

The reflective electrode layer RL may be located on the seventh interlayer insulating layer INS7. The reflective electrode layer RL may include one or more reflective electrodes (RL1, RL2, RL3, and RL4). For example, referring to FIG. 12, the reflective electrode RL may include first reflective electrodes RL1, second reflective electrodes RL2, third reflective electrodes RL3, and fourth reflective electrodes RL4.

The first reflective electrodes RL1 may be located on the seventh interlayer insulating layer INS7, and may be connected to vias that penetrate the seventh interlayer insulating layer INS7. The first reflective electrodes RL1 may be formed of Cu, Al, W, Mo, Cr, Au, Ti, Ni, Nd, or an alloy thereof. For example, the first reflective electrodes RL1 may include titanium nitride (TiN).

The second reflective electrodes RL2 may be located on the first reflective electrodes RL1. The second reflective electrodes RL2 may be formed of Cu, Al, W, Mo, Cr, Au, Ti, Ni, Nd, or an alloy thereof. For example, the second reflective electrodes RL2 may include Al.

The third reflective electrodes RL3 may be located on the second reflective electrodes RL2. The third reflective electrodes RL3 may be formed of Cu, Al, W, Mo, Cr, Au, Ti, Ni, Nd, or an alloy thereof. For example, the third reflective electrodes RL3 may include TiN.

The fourth reflective electrodes RL4 may be located on the third reflective electrodes RL3. The fourth reflective electrodes RL4 may be formed of Cu, Al, W, Mo, Cr, Au, Ti, Ni, Nd, or an alloy thereof. For example, the fourth reflective electrodes RL4 may include Ti.

The thickness of the second reflective electrodes RL2, which are electrodes substantially reflecting light from the light-emitting elements, may be greater than the thicknesses of the first reflective electrodes RL1, the third reflective electrodes RL3, and the fourth reflective electrodes RL4. For example, the thicknesses of the first reflective electrodes RL1, the third reflective electrodes RL3, and the fourth reflective electrodes RL4 may be approximately 100 Å, and the thickness of the second reflective electrodes RL2 may be approximately 850 Å.

The eighth interlayer insulating layer INS8 may be located on the seventh interlayer insulating layer INS7. The eighth interlayer insulating layer INS8 may be located between neighboring parts of the reflective electrode layers RL. The eighth interlayer insulating layer INS8 may also be located on the reflective electrode layer RL in the first sub-pixels SP1. The eighth interlayer insulating layer INS8 may be formed as a SiOx-based inorganic film, but the present disclosure is not limited thereto.

The ninth interlayer insulating layer INS9 may be located on the eighth interlayer insulating layer INS8 and the reflective electrode layer RL. The ninth interlayer insulating layer INS9 may be formed as a SiOx-based inorganic film, but the present disclosure is not limited thereto.

In the first subpixels SP1, the second subpixels SP2, and/or the third subpixels SP3, the eighth and ninth interlayer insulating layers INS8 and INS9 may not be located below the first electrodes AND in consideration of the resonance distance of light emitted from the light-emitting elements.

For example, the first electrodes AND of the third subpixels SP3 may be directly located on the fourth reflective electrodes RL4, and may not overlap with the eighth and ninth interlayer insulating layers INS8 and INS9. The first electrodes AND of the second subpixels SP2 may be located on the ninth interlayer insulating layer INS9, and the ninth interlayer insulating layer INS9 may be located directly on the fourth reflective electrodes RL4. Thus, the first electrodes AND of the second subpixels SP2 may not overlap with the eighth interlayer insulating layer INS8. The first electrodes AND of the first subpixels SP1 may be located on the ninth interlayer insulating layer INS9 and may overlap with the eighth interlayer insulating layer INS8.

In one or more embodiments, the distance between the first electrodes AND and the reflective electrode layer RL may differ among the first subpixels SP1 to the second subpixels SP2 to the third subpixels SP3. Depending on the main wavelength of light emitted from each of the subpixels (SP1, SP2, and SP3), the presence or absence of the eighth and ninth interlayer insulating layers INS8 and INS9 in each of the subpixels (SP1, SP2, and SP3) may be determined to adjust the distance from the reflective electrode layer RL to a second electrode CAT. For example, as illustrated in FIG. 12, the distance between the first electrodes AND and the reflective electrode layer RL may be greater in the first subpixels SP1 than in the second subpixels SP2 and than in the third subpixels SP3, and may be greater in the second subpixels SP2 than in the third subpixels SP3. However, the present disclosure is not limited thereto. The distance between the first electrodes AND of the subpixels (SP1, SP2, and SP3) and the reflective electrode layer RL may be varied and designed differently.

FIG. 12 illustrates the presence of the eighth and ninth interlayer insulating layers INS8 and INS9, and a tenth interlayer insulating layer may be further located below the first electrodes AND of the subpixels (SP1, SP2, and SP3). In this case, the ninth interlayer insulating layer INS9 and the tenth interlayer insulating layer may both be located below the first electrodes AND of the second subpixels SP2, and the eighth interlayer insulating layer INS8, the ninth interlayer insulating layer INS9, and the tenth interlayer insulating layer may be located below the first electrodes AND of the first subpixels SP1.

Electrode vias VAP may be connected to the fourth reflective electrodes RL4 exposed through the eighth interlayer insulating layer INS8 and/or the ninth interlayer insulating layer INS9 in the first subpixels SP1 and the second subpixels SP2. The electrode vias VAP may be formed of Cu, Al, W, Mo, Cr, Au, Ti, Ni, Nd, or an alloy thereof. The thickness of the electrode vias VAP may be smaller in the second subpixels SP2 than in the first subpixels SP1.

The display element layer 230 may be located on the emitter backplane EBP. The display element layer 230 may include the light-emitting element layer EML, the encapsulation layer TFE, an optical layer OPL, and the cover layer DCL. The display element layer 230 may include the light-emitting elements that are electrically connected to the pixel circuit part 220 and the driving part 100 to emit light.

The light-emitting element layer EML may be located on the reflective layer IL and the ninth interlayer insulating layer INS9. The light-emitting element layer EML may include the light-emitting elements, the pixel-defining films PDL, and the trenches TRC and the light-emitting elements may include the first electrodes AND, a light-emitting stack IL, and the second electrode CAT.

The first electrodes AND of the light-emitting elements may be located on the ninth interlayer insulating layer INS9 or the reflective electrode layer RL, and may be connected to the electrode vias VAP. The first electrodes AND of the light-emitting elements may be connected to the second transistors PTR2 through the electrode vias VAP, the first reflective electrodes RL1, the second reflective electrodes RL2, the third reflective electrodes RL3, the fourth reflective electrodes RL4, the routing conductive layers RMT, and the contact electrodes CTE. The first electrodes AND of the light-emitting elements may be formed of Cu, Al, W, Mo, Cr, Au, Ti, Ni, Nd, or an alloy thereof. For example, the first electrodes AND of the light-emitting elements may include TiN.

The pixel-defining films PDL may be located over parts of the first electrodes AND of the light-emitting elements. The pixel-defining films PDL may cover the edges of the first electrodes AND of the light-emitting elements. The pixel-defining films PDL may define and separate the first light-emitting areas EA1, the second light-emitting areas EA2, and the third light-emitting areas EA3.

The first light-emitting areas EA1 may be defined as areas in the first subpixels SP1 where the first electrodes AND, the light-emitting stack IL, and the second electrode CAT are sequentially stacked to emit light. The second light-emitting areas EA2 may be defined as areas in the second subpixels SP2 where the first electrodes AND, the light-emitting stack IL, and the second electrode CAT are sequentially stacked to emit light. The third light-emitting areas EA3 may be defined as areas in the third subpixels SP3 where the first electrodes AND, the light-emitting stack IL, and the second electrode CAT are sequentially stacked to emit light.

The pixel-defining films PDL may include the first, second, and third pixel-defining films PDL1, PDL2, and PDL3. The first pixel-defining film PDL1 may be located over the edges of the first electrodes AND of the light-emitting elements, the second pixel-defining film PDL2 may be located on the first pixel-defining film PDL1, and the third pixel-defining film PDL3 may be located on the second pixel-defining film PDL2. The first, second, and third pixel-defining films PDL1, PDL2, and PDL3 may be formed as SiOₓ-based inorganic films, but the present disclosure is not limited thereto. The thickness of the first, second, and third pixel-defining films PDL1, PDL2, and PDL3 may be approximately 500 Å.

If a single pixel-defining film PDL is formed, instead of the first, second, and third pixel-defining films PDL1, PDL2, and PDL3, the single pixel-defining film PDL may become too high, possibly leading to discontinuities in a first inorganic encapsulation layer TFE1 due to step coverage. Step coverage may refer to the ratio of the thickness of a thin film applied on a flat surface to the thickness of the thin film applied on an inclined surface, and the lower the step coverage may mean the higher the likelihood of the thin film being disconnected on an inclined surface.

To reduce or prevent the likelihood of discontinuities in the first inorganic encapsulation layer TFE1 due to step coverage, the first, second, and third pixel-defining films PDL1, PDL2, and PDL3 may have a stepped cross-sectional structure. For example, the width of the first pixel-defining film PDL1 may be greater than the widths of the second and third pixel-defining films PDL2 and PDL3, and the width of the second pixel-defining film PDL2 may be greater than the width of the third pixel-defining film PDL3. The width of the first pixel-defining film PDL1 refers to the length, in a horizontal direction (e.g., the first or second direction DR1 or DR2), of the first pixel-defining film PDL1.

The trenches TRC may penetrate the first, second, and third pixel-defining films PDL1, PDL2, and PDL3. In the trenches TRC, the eighth interlayer insulating layer INS8 may be partially dented, and the ninth interlayer insulating layer INS9 may be completely penetrated.

One or more trenches TRC may be located between the subpixels (SP1, SP2, and SP3). FIGS. 12 and 13 illustrate that two trenches TRC are located between the subpixels (SP1, SP2, and SP3), but the present disclosure is not limited thereto.

The light-emitting stack IL may include a plurality of intermediate layers. The light-emitting stack IL may have a 3-tandem structure with first, second, and third intermediate layers IL1, IL2, and IL3, but the present disclosure is not limited thereto. Alternatively, the light-emitting stack IL may have a 2-tandem structure with two intermediate layers.

The light-emitting stack IL may have a 3-tandem structure with a plurality of intermediate layers for emitting different colors of light. For example, the light-emitting stack IL may include a first intermediate layer IL1 that emits the first-color light, a second intermediate layer IL2 that emits the third-color light, and a third intermediate layer IL3 that emits the second-color light. The first, second, and third intermediate layers IL1, IL2, and IL3 may be sequentially stacked.

The first intermediate layer IL1 may have a structure where a first hole transport layer, a first organic light-emitting layer for emitting the first-color light, and a first electron transport layer are sequentially stacked. The second intermediate layer IL2 may have a structure where a second hole transport layer, a second organic light-emitting layer for emitting the third-color light, and a second electron transport layer are sequentially stacked. The third intermediate layer IL3 may have a structure where a third hole transport layer, a third organic light-emitting layer for emitting the second-color light, and a third electron transport layer are sequentially stacked.

A first charge generation layer for supplying charges to the second intermediate layer IL2 and electrons to the first intermediate layer IL1 may be located between the first and second intermediate layers IL1 and IL2. The first charge generation layer may include an N-type charge generation layer that supplies electrons to the first intermediate layer IL1, and may include a P-type charge generation layer that supplies holes to the second intermediate layer IL2. The N-type charge generation layer may include a dopant of a metal material.

A second charge generation layer for supplying charges to the third intermediate layer IL3 and for supplying electrons to the second intermediate layer IL2 may be located between the second and third intermediate layers IL2 and IL3. The second charge generation layer may include an N-type charge generation layer that supplies electrons to the second intermediate layer IL2, and may include a P-type charge generation layer that supplies holes to the third intermediate layer IL3.

The first intermediate layer IL1 may be located on the first electrodes AND and the pixel-defining films PDL, and may be placed at the bottom surfaces of the trenches TRC. Due to the trenches TRC, the first intermediate layer IL1 may be disconnected between the subpixels (SP1, SP2, and SP3). The second intermediate layer IL2 may be located on the first intermediate layer IL1. Due to the trenches TRC, the second intermediate layer IL2 may be disconnected between the subpixels (SP1, SP2, and SP3). Cavities or empty spaces may be located between the first and second intermediate layers IL1 and IL2. The third intermediate layer IL3 may be located on the second intermediate layer IL2. The third intermediate layer IL3 may not be disconnected by the trenches TRC, and may be located to cover the second intermediate layer IL2 in the trenches TRC. That is, in a 3-tandem structure, the trenches TRC may serve as structures for disconnecting the first and second intermediate layers IL1 and IL2 and the first and second charge generation layers of the light-emitting element layer EML between the subpixels (SP1, SP2, and SP3), and in a 2-tandem structure, the trenches TRC may serve as structures for disconnecting a lower intermediate layer and a charge generation layer located between the lower intermediate layer and an upper intermediate layer.

To reliably disconnect the first and second intermediate layers IL1 and IL2 of the light-emitting element layer EML between the subpixels (SP1, SP2, and SP3), the height of the trenches TRC may be greater than the height of the pixel-defining films PDL. The height of the trenches TRC refers to the length of the trenches TRC in the third direction DR3. The height of the pixel-defining films PDL refers to the length of the pixel-defining film PDL in the third direction DR3. To disconnect the first, second, and third intermediate layers IL1, IL2, and IL3 of the light-emitting element layer EML between the subpixels (SP1, SP2, and SP3), another structure may be provided instead of trenches TRC. For example, reverse-tapered partitions may be located on the pixel-defining films PDL.

The number of intermediate layers (IL1, IL2, and IL3) emitting different colors of light is not particularly limited. Alternatively, for example, the light-emitting stack IL may include two intermediate layers. In this case, one of the two intermediate layers may be substantially identical to the first intermediate layer IL1, and the other intermediate layer may include the second hole transport layer, the second organic light-emitting layer, the third organic light-emitting layer, and the second electron transport layer. Additionally, a charge generation layer may be located between the two intermediate layers to supply electrons to one of the two intermediate layers and charges to the other intermediate layer.

FIGS. 12 and 13 illustrate that the first, second, and third intermediate layers IL1, IL2, and IL3 are all located the first light-emitting areas EA1, the second light-emitting areas EA2, and the third light-emitting areas EA3, respectively, but the present disclosure is not limited thereto. Alternatively, the first intermediate layer IL1 may be located in the first light-emitting areas EA1, but not in the second light-emitting areas EA2 and the third light-emitting areas EA3. The second intermediate layer IL2 may be located in the second light-emitting areas EA2, but not in the first light-emitting areas EA1 and the third light-emitting areas EA3. The third intermediate layer IL3 may be located in the third light-emitting areas EA3, but not in the first light-emitting areas EA1 and the second light-emitting areas EA2. In this case, a plurality of color filters (CF1, CF2, and CF3) of the optical layer OPL may not be provided.

The second electrode CAT may be located on the third intermediate layer IL3. For example, the second electrode CAT may also be located on the third intermediate layer IL3 within each of the trenches TRC. The second electrode CAT may be formed of a transparent conductive oxide (TCO), such as indium tin oxide (ITO) or indium zinc oxide (IZO) or a semi-transmissive conductive material, such as magnesium (Mg), silver (Ag), or an alloy thereof. If the second electrode CAT is formed of a semi-transmissive conductive material, the light emission efficiency of the subpixels (SP1, SP2, and SP3) can be enhanced due to the micro-cavity, etc.

The encapsulation layer TFE may be located on the light-emitting element layer EML. The encapsulation layer TFE may include at least one inorganic encapsulation layer to reduce or prevent the infiltration of oxygen or moisture into the light-emitting element layer EML. Additionally, the encapsulation layer TFE may include at least one organic layer to protect the light-emitting element layer EML from foreign substances, such as dust. For example, the encapsulation layer TFE may include a first inorganic encapsulation layer TFE1, an organic encapsulation layer TFE2, and a second inorganic encapsulation layer TFE3.

The first inorganic encapsulation layer TFE1 may be located on the second electrode CAT, the organic encapsulation layer TFE2 may be located on the first inorganic encapsulation layer TFE1, and the second inorganic encapsulation layer TFE3 may be located on the organic encapsulation layer TFE2. The first and second inorganic encapsulation layers TFE1 and TFE3 may be formed as multilayer films, where one or more inorganic films of silicon nitride (SiNₓ), silicon oxynitride (SiOₓN_{y}), SiOₓ, TiOₓ, and/or aluminum oxide (AlOₓ) are alternately stacked. The organic encapsulation layer TFE2 may be a monomer. The organic encapsulation layer TFE2 may be an organic film, such as a film of an acryl resin, epoxy resin, phenolic resin, polyamide resin, or polyimide resin.

The adhesive layer ADL may be located on the encapsulation layer TFE. The adhesive layer ADL may be a layer for bonding the encapsulation layer TFE with other layers. The adhesive layer ADL may be a double-sided adhesive member. Additionally, the adhesive layer ADL may be a transparent adhesive or a transparent adhesive resin.

The optical layer OPL may include the color filter layer CFL, the lenses LNS, and a filling layer FIL. The color filter layer CFL may include first color filters CF1, second color filters CF2, and third color filters CF3. The first color filters CF1, the second color filters CF2, and the third color filters CF3 may be located on the adhesive layer ADL.

The first color filters CF1 may overlap with the first light-emitting areas EA1. The first color filters CF1 may transmit the first-color light (e.g., light in a red wavelength range). The red wavelength range may be about 600 nm to about 750 nm. The first color filters CF1 may transmit therethrough the first-color light emitted from the first light-emitting areas EA1.

The second color filters CF2 may overlap with the second light-emitting areas EA2. The second color filters CF2 may transmit the second-color light (e.g., light in a green wavelength range). The green wavelength range may be about 480 nm to about 560 nm. The second color filters CF2 may transmit therethrough the second-color light emitted from the second light-emitting areas EA2.

The third color filters CF3 may overlap with the third light-emitting areas EA3. The third color filters CF3 may transmit the third-color light (e.g., light in a blue wavelength range). The blue wavelength range may be about 370 nm to about 460 nm. The third color filters CF3 may transmit therethrough the third-color light emitted from the third light-emitting area EA3.

The lenses LNS may be respectively located on the first color filters CF1, the second color filters CF2, and the third color filters CF3. The lenses LNS may be for increasing the ratio of light directed toward the front of the display device 10. The lenses LNS may have a convex cross-sectional shape in an upward direction.

The filling layer FIL may be located on the lenses LNS. The filling layer FIL may have a refractive index (e.g., predetermined refractive index) to allow light to travel in the third direction DR3 at the interface between the lenses LNS and the filling layer FIL. Furthermore, the filling layer FIL may be a planarization layer. The filling layer FIL may be an organic film of an acryl resin, epoxy resin, phenolic resin, polyamide resin, or polyimide resin.

The cover layer DCL may be located on the filling layer FIL. The cover layer DCL may be a glass substrate or a polymer resin. If the cover layer DCL is a glass substrate, the cover layer DCL may be attached on the filling layer FIL. In this case, the filling layer FIL may serve as an adhesive for bonding the cover layer DCL. If the cover layer DCL is a glass substrate, the cover layer DCL may also function as an encapsulation substrate. If the cover layer DCL is a polymer resin, the cover layer DCL may be directly applied on the filling layer FIL.

In one or more embodiments, the display part 200 may further include a polarizer located on the cover layer DCL. The polarizer may be located on one surface of the cover layer DCL. The polarizer may serve as a structure for reducing or preventing reduction in visibility due to external light reflection. The polarizer may include a linear polarizer and a phase retardation film. For example, the phase retardation film may be a quarter-wave plate (e.g., a λ/4 plate), but the present disclosure is not limited thereto. However, if the visibility reduction caused by external light reflection is sufficiently improved by the color filters (CF1, CF2, and CF3), the polarizer may not be provided.

Various embodiments of the display device 10 will hereinafter be described with reference to the other drawings.

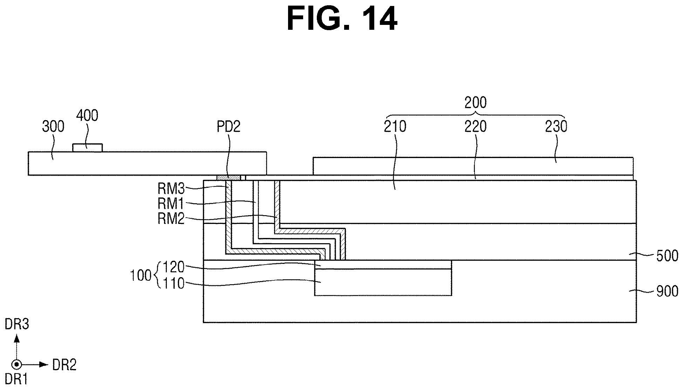

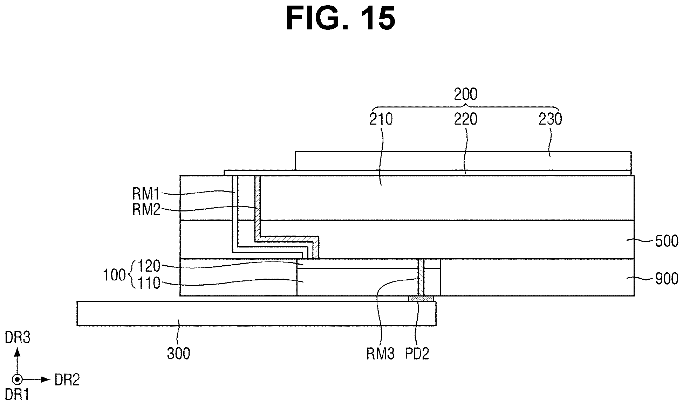

FIGS. 14 and 15 are cross-sectional views of display devices according to other embodiments of the present disclosure.

Referring to FIG. 14, a drive circuit part 400 of a driving part 100 may be located on a circuit board 300. The drive circuit part 400 may be located on the circuit board 300 as a separate chip, without including first transistors PTR1 formed on a first monocrystalline semiconductor substrate 110 of the driving part 100. Consequently, a gate-driving part (610 and 620) may be electrically connected to the drive circuit part 400 through second pads PD2 in a display part 200, and a data drive part 700 may be electrically connected to the drive circuit part 400 through second routing wires RM2. In one or more embodiments, the second routing wires RM2 may be electrically connected to the circuit board 300 and the drive circuit part 400 through the second pads PD2.

Referring to FIG. 15, a circuit board 300 may be located on the back side of a driving part 100. A first monocrystalline semiconductor substrate 110 of the driving part 100 may include/define through holes, which penetrate the first monocrystalline semiconductor substrate 110. Third routing wires RM3 may be located in the through holes. The circuit board 300 may be attached to the back side of the driving part 100 and a protective layer 900, and may be electrically connected to a drive circuit part 400 and/or a data drive part 700 of the driving part 100 through the third routing wires RM3, positioned in the through holes penetrating the first monocrystalline semiconductor substrate 110.

In one or more embodiments, third through holes TSV3 may be omitted in a second monocrystalline semiconductor substrate 210 of a display part 200, and only first through holes TSV1 and second through holes TSV2 may be formed in the second monocrystalline semiconductor substrate 210. The display part 200 and the driving part 100 may be connected to each other through first routing wires RM1 and second routing wires RM2.

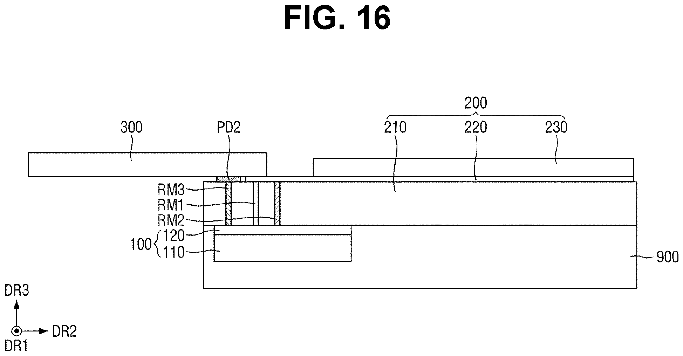

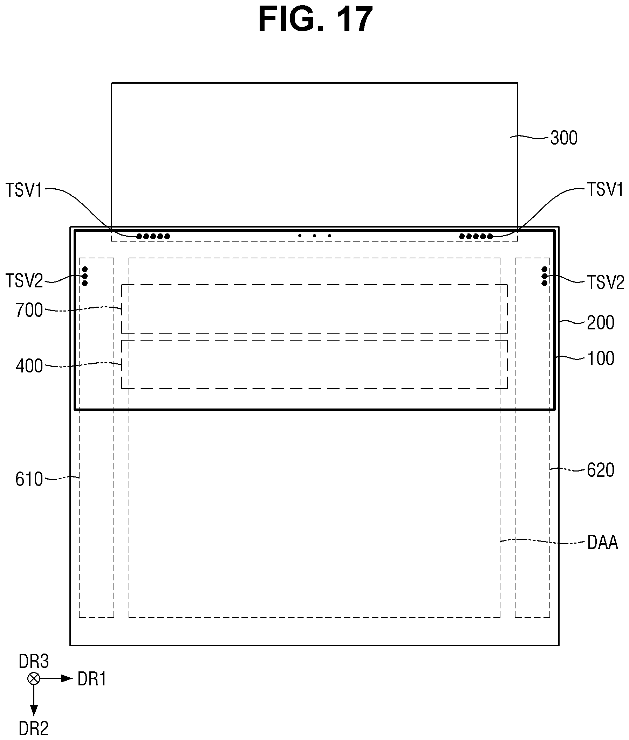

FIG. 16 is a cross-sectional view of a display device according to one or more other embodiments of the present disclosure. FIG. 17 is a bottom view of the display device of FIG. 16.

Referring to FIGS. 16 and 17, a display device 10 may not include a connection wiring layer 500, and a plurality of through holes (TSV1, TSV2, and TSV3) and routing wires (RM1, RM2, and RM3) may overlap with a driving part 100. The driving part 100 may have a larger area than its counterpart of FIGS. 7 and 8, and may overlap with the through holes (TSV1, TSV2, and TSV3), which are formed in a display part 200. As the area of the driving part 100 increases, terminals that are connected to the routing wires (RM1, RM2, and RM3) may be formed in the driving part 100 at locations corresponding to the through holes (TSV1, TSV2, and TSV3). The routing wires (RM1, RM2, and RM3) may only include conductive vias (RVA1, RVA2, and RVA3), which are located within the through holes (TSV1, TSV2, and TSV3), and the conductive vias (RVA1, RVA2, and RVA3) may directly contact terminals formed in a drive circuit layer 120 of the driving part 100. For example, first routing wires RM1 may directly contact terminals connected to a data drive part 700, second routing wires RM2 may directly contact terminals connected to a drive circuit part 400, and third routing wires RM3 may directly contact first pads PD1.

The driving part 100 may have a smaller area than the display part 200, but may be large enough to cover the area where the through holes (TSV1, TSV2, and TSV3) are located. Therefore, connection wires of the routing wires (RM1, RM2, and RM3) that connect the through holes (TSV1, TSV2, and TSV3) and the driving part 100 may not be provided.

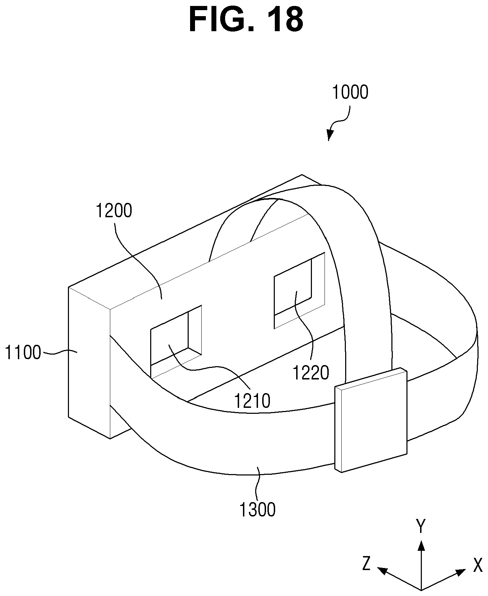

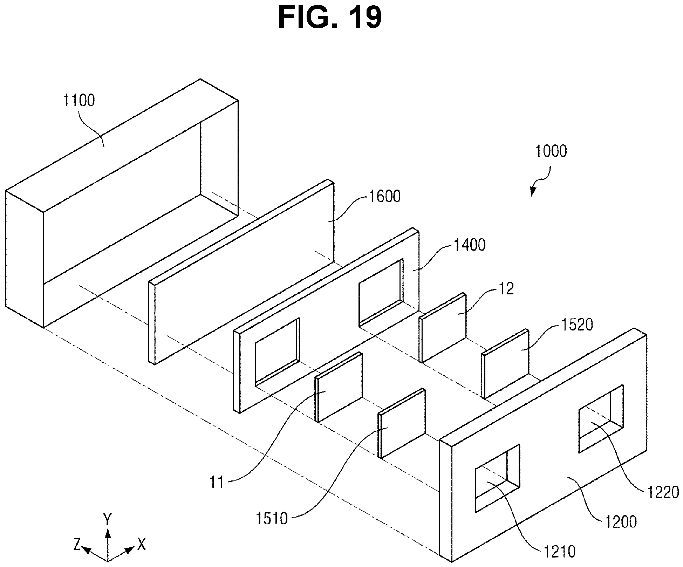

FIG. 18 is a perspective view of an HMD device according to one or more embodiments of the present disclosure. FIG. 19 is an exploded perspective view of the HMD device of FIG. 18.

Referring to FIGS. 18 and 19, an HMD device 1000 may include a first display device 11, a second display device 12, a display device housing 1100, a housing cover 1200, a first eyepiece lens 1210, a second eyepiece lens 1220, a head-mounting band 1300, a middle frame 1400, a first optical member 1510, a second optical member 1520, a control circuit board 1600, and connectors.

The first display device 11 provides an image to a user's left eye, and the second display device 12 provides an image to the user's right eye. As the first and second display devices 11 and 12 are substantially the same as the display device 10 of FIG. 1, detailed descriptions of the first and second display devices 11 and 12 will be omitted.

The first optical member 1510 may be located between the first display device 11 and the first eyepiece lens 1210. The second optical member 1520 may be located between the second display device 12 and the second eyepiece lens 1220. Each of the first and second optical members 1510 and 1520 may include at least one convex lens.

The middle frame 1400 may be located between the first display device 11 and the control circuit board 1600, as well as between the second display device 12 and the control circuit board 1600. The middle frame 1400 supports and secures the first display device 11, the second display device 12, and the control circuit board 1600.

The control circuit board 1600 may be located between the middle frame 1400 and the display device housing 1100. The control circuit board 1600 may be connected to the first and second display devices 11 and 12 through the connectors. The control circuit board 1600 may convert an external video source into digital video data DATA and may transmit the digital video data DATA to the first and second display devices 11 and 12 through the connectors.

The control circuit board 1600 may transmit digital video data DATA corresponding to an image suitable or optimized for the user's left eye to the first display device 11, and digital video data DATA corresponding to an image suitable or optimized for the user's right eye to the second display device 12. Alternatively, the control circuit board 1600 may transmit the same digital video data DATA to both the first and second display devices 11 and 12.

The display device housing 1100 accommodates the first display device 11, the second display device 12, the middle frame 1400, the first optical member 1510, the second optical member 1520, the control circuit board 1600, and the connectors. The housing cover 1200 is located to cover the open side of the display device housing 1100. The housing cover 1200 may include the first eyepiece lens 1210 for the user's left eye and the second eyepiece lens 1220 for the user's right eye. FIG. 18 illustrates that the first and second eyepiece lenses 1210 and 1220 are separate, but the present disclosure is not limited thereto. Alternatively, the first and second eyepiece lenses 1210 and 1220 may be integrated into a single unit.

The first eyepiece lens 1210 is aligned with the first display device 11 and the first optical member 1510, and the second eyepiece lens 1220 is aligned with the second display device 12 and the second optical member 1520. Consequently, the user can view the image from the first display device 11, magnified as a virtual image by the first optical member 1510, through the first eyepiece lens 1210, and may also view the image from the second display device 12, magnified as a virtual image by the second optical member 1520, through the second eyepiece lens 1220.

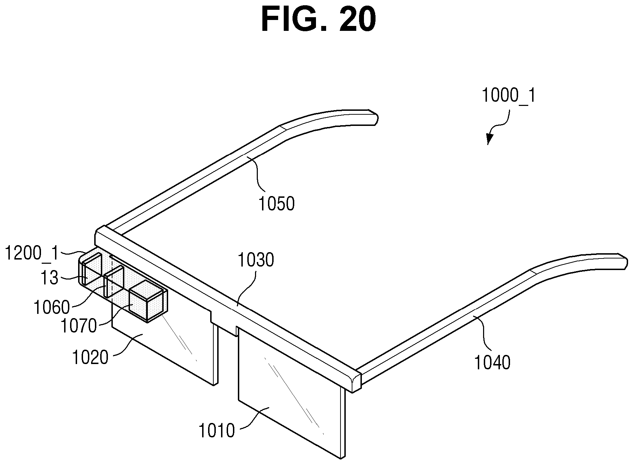

The head-mounting band 1300 secures the display device housing 1100 to the user's head, ensuring that the first and second eyepiece lenses 1210 and 1220 remain correctly positioned over the user's left and right eyes, respectively. If the display device housing 1200 is implemented to be lightweight and compact, the HMD device 1000 may be equipped with an eyeglass frame, as illustrated in FIG. 20, instead of the head-mounting band 1300.

Additionally, the HMD device 1000 may further include a battery for supplying power, an external memory slot for accommodating an external memory, and an external connection port and a wireless communication module for receiving video sources. The external connection port may be a universal serial bus (USB) port, display port, or high-definition multimedia interface (HDMI) port, and the wireless communication module may include a 5G module, 4G module, Wi-Fi module, or Bluetooth module.

FIG. 20 is a perspective view of an HMD device according to one or more other embodiments of the present disclosure.

Referring to FIG. 20, an HMD device 1000_1 may be in the form of eyeglasses with a display device housing 1200_1, which is lightweight and compact. The HMD device 1000_1 may include a display device 13, a left eyepiece lens 1010, a right eyepiece lens 1020, a support frame 1030, eyeglass temples 1040 and 1050, an optical member 1060, an optical path conversion member 1070, and the display device housing 1200_1.

The display device housing 1200_1 may include the display device 13, the optical member 1060, and the optical path conversion member 1070. An image displayed on the display device 13 may be magnified by the optical member 1060, and its optical path may be altered by the optical path conversion member 1070 to be delivered to a user's right eye through the right eyepiece lens 1020. As a result, the user may view an AR image into which a virtual image displayed on the display device 13 and a real image seen through the right eyepiece lens 1020 are combined.

The display device housing 1200_1 is illustrated as being located at the right end of the support frame 1030, but the present disclosure is not limited thereto. Alternatively, the display device housing 1200_1 may be located at the right end of the support frame 1030, in which case, the image from the display device 13 may be provided to the user's right eye. Alternatively, the display device housing 1200_1 may be located at both the left and right ends of the support frame 1030, in which case, the user may view the image from the display device 13 through both eyes.

In concluding the detailed description, those skilled in the art will appreciate that many variations and modifications can be made to the embodiments without substantially departing from the aspects of present disclosure. Therefore, the disclosed embodiments of present disclosure are used in a generic and descriptive sense only and not for purposes of limitation.

## Claims

1. A display device comprising:
a first monocrystalline semiconductor substrate where first transistors are located; and
a second monocrystalline semiconductor substrate where second transistors are located, having a planar area that is greater than a planar area of the first monocrystalline semiconductor substrate, located above the first monocrystalline semiconductor substrate, comprising a display area where subpixels comprising light-emitting elements are located, defining first through holes in which first conductive vias that are electrically connected to data lines, which are connected to the subpixels, are located, and defining second through holes in which second conductive vias that are electrically connected to a gate-driving part, which is electrically connected to the subpixels, are located.

2. The display device of claim 1, wherein a number of the first through holes is greater than a number of the second through holes.

3. The display device of claim 1 or 2, wherein a number of the first through holes is equal to a number of rows of the subpixels.

4. The display device of any preceding claim, further comprising a circuit board above pads, which pads are located in a non-display area around the display area of the second monocrystalline semiconductor substrate,
wherein the second monocrystalline semiconductor substrate defines third through holes overlapping the pads.

5. The display device of claim 4, wherein the first through holes overlap with the circuit board in a thickness direction.

6. The display device of claim 4, wherein the third through holes overlap the circuit board and the first monocrystalline semiconductor substrate.

7. The display device of claim 4, wherein the first through holes do not overlap with the pads.

8. The display device of any of claims 1 to 3, further comprising a circuit board on a bottom surface of the first monocrystalline semiconductor substrate,
wherein the first monocrystalline semiconductor substrate defines third through holes in which there are conductive vias connected to the circuit board.

9. The display device of claim 8, further comprising a drive circuit part on the circuit board.

10. The display device of any preceding claim, wherein a width of the first monocrystalline semiconductor substrate in one direction is greater than a width of the display area in the one direction.

11. The display device of any preceding claim, wherein the first through holes and the second through holes are in a non-display area around the display area in plan view.

12. The display device of any preceding claim, wherein the data lines extend in a first direction above the second monocrystalline semiconductor substrate, and are electrically connected to some of the first transistors, and
wherein the display device further comprises scan lines electrically connected to the gate-driving part, and extending in a second direction crossing the first direction above the second monocrystalline semiconductor substrate.

13. The display device of claim 12, wherein the first through holes are arranged in parallel to the data lines along the first direction, and or wherein a number of the first through holes is equal to a number of the data lines.

14. The display device of any preceding claim, further comprising a connection wiring layer between the first and second monocrystalline semiconductor substrates, and connected to the first conductive vias and the second conductive vias.

15. A head-mounted display (HMD) device comprising:
a frame configured to be worn on a user's body, and corresponding to a user's eyes;
one or more display devices in the frame; and
a lens above the or each display device,
wherein the or each display device comprises a display device according to any of the preceding claims.
